# EUROPEAN PATENT APPLICATION

(11) **EP 4 421 843 A1**
(43) Date of publication of application: **28.08.2024**
(21) Application number: 23158846.8
(22) Date of filing: 27.02.2023
(51) Int. Cl.: H01J 37/317, H01J 37/22

(54) **CHARGED PARTICLE-OPTICAL APPARATUS**

(71) Applicant: ASML Netherlands B.V., 5500 AH Veldhoven (NL)
(72) Inventor: VAN ENGELEN, Jorn, Paul, 5500 AH Veldhoven (NL); SAHIN, Ezgi, 5500 AH Veldhoven (NL); AKBULUT, Duygu, 5500 AH Veldhoven (NL); PELLEMANS, Henricus, Petrus, Maria, 5500 AH Veldhoven (NL); WIELAND, Marco, Jan-Jaco, 5500 AH Veldhoven (NL); SLOT, Erwin, 5500 AH Veldhoven (NL); KUIPER, Vincent, Sylvester, 5500 AH Veldhoven (NL)
(74) Representative: ASML Netherlands B.V.

(57) **Abstract**

An electron-optical projection device for projecting a plurality of charged particle beams towards a sample, the device comprising:
a stack of plates comprising beam directing elements configured to project the plurality of charged particle beams towards a sample location on the sample,
wherein at least one plate of the stack comprises a planar optical member configured to direct stimulation light towards the sample location so that the stimulation light is coincident with the plurality of charged particle beams, desirably coincident with the paths of the plurality of charged particle beams towards the sample location, desirably in the at least one plate comprising an optical member is defined a plurality of apertures for respective paths of a plurality charged particle beams.

## Description

### FIELD

The embodiments provided herein generally relate to charged particle-optical apparatuses and methods for assessing a sample.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscatter electrons or Auger electrons, which may be referred to as signal particles. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain an image representing characteristics of the material structure of the surface of the sample. The intensity of the electron beams comprising the backscatter electrons and the secondary electrons may vary based on the properties of the internal and external structures of the sample, and thereby may indicate whether the sample has defects.

When the primary electron beam scans the sample, charges may be accumulated on the sample due to large beam current, which may affect the quality of the image. The material structure may be illuminated with light and/or flooded with electrons in order to improve the defect contrast during defect inspection. For example, to regulate the accumulated charges on the sample, an Advanced Charge Controller (ACC) module may be employed to illuminate a light beam, such as a laser beam, on the sample, so as to control the accumulated charges due to effects such as photoconductivity, photoelectric, or thermal effects. The term ACC is used in the description below as shorthand for illumination by a light beam. It is to be understood that the term ACC refers generally to illumination by a light beam. It can be difficult to illuminate the light beam on the sample. For example, the dimensions of the pattern inspection tool may make it difficult to reach the sample with the light beam.

### SUMMARY

It is an object of the present disclosure to provide embodiments that enable irradiating light onto a sample simultaneously with assessments to provide improved defect contrast.

According to a first aspect of the invention, there is provided a plate for an electron-optical device configured to project a plurality of charged particle beams towards a sample, the device comprising the plate within the stack of plates, wherein
in the plate is defined a plurality of apertures for respective paths of a plurality charged particle beams, and
the plate comprises a planar optical member configured to direct stimulation light towards a sample so that the stimulation light is coincident with the paths of the plurality of charged particle beams towards the sample.

According to a second aspect of the invention, there is provided a stimulation module for use in an electron-optical projection device for projecting a plurality of charged particle beams towards a sample, the module comprising:
a planar optical member configured to direct stimulation light towards a sample so that the stimulation light is coincident with the plurality of charged particle beams, in the plate is defined a plurality of apertures for respective paths of a plurality charged particle beams, and desirably the planar optical member is comprised a plate for example of a stack of plates arranged along the paths of a plurality of charged particle beams towards a sample.

According to a third aspect of the invention, there is provided an electron-optical projection device for projecting a plurality of charged particle beams towards a sample, the device comprising:
a stack of plates comprising beam directing elements configured to project the plurality of charged particle beams towards a sample location on the sample,
wherein at least one plate of the stack comprises a planar optical member configured to direct stimulation light towards the sample location so that the stimulation light is coincident with the plurality of charged particle beams, desirably coincident with the paths of the plurality of charged particle beams towards the sample location, desirably in the at least one plate comprising an optical member is defined a plurality of apertures for respective paths of a plurality charged particle beams.

According to a fourth aspect of the invention, there is provided an assessment charged particle-optical apparatus or a preparatory charged particle-optical apparatus comprising a device as described above, desirably when a planar optical element is located in an up-beamward direction of the device.

According to a fifth aspect of the invention, there is provided an assessment method using the device described above.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary electron beam inspection apparatus.
**FIG. 2** is a schematic diagram illustrating an exemplary multi-beam electron-optical apparatus that is part of the exemplary electron beam inspection apparatus of **FIG. 1****.**
**FIG. 3** is a schematic diagram of an exemplary multi-beam electron-optical apparatus.
**FIG. 4** is a schematic diagram of an exemplary electron-optical apparatus comprising a macro collimator and macro scan deflector.
**FIG. 5** is a schematic diagram of an exemplary multi-beam electron-optical apparatus according to an embodiment.
**FIG. 6** is a schematic diagram of part of the multi-beam electron-optical apparatus of **FIG.** 5.
**FIG. 7** is a schematic cross-sectional view of an objective lens array of an electron-optical apparatus according to an embodiment.
**FIG. 8** is a bottom view of a modification of the objective lens array of **FIG. 7****.**
**FIG. 9** is an enlarged schematic cross-sectional view of a detector incorporated in the objective lens array of **FIG. 7****.**
**FIG. 10** is a bottom view of a detector element of a detector.
**FIG. 11** is a schematic diagram of an electron-optical apparatus for assessing a sample.
**FIG. 12** is a schematic cross-sectional view of a planar optical member incorporated in an electron-optical device.
**FIG. 13** is a schematic cross-sectional view of another planar optical member incorporated in an electron-optical device.
**FIG. 14** is a schematic cross-sectional view of another planar optical member incorporated in an electron-optical device.
**FIG. 15** is an enlarged cross-sectional view of the arrangement of **FIG. 13****.**
**FIG. 16** is schematic plan view of an optical system arrangement featuring waveguides incorporated in an electron-optical device.
**FIG. 17** is a schematic plan of an optical system arrangement featuring an optical fibre incorporated in an electron-optical device.
**FIG. 18** is an enlarged cross-sectional view of the arrangement of **FIG. 17****.**
**FIG. 19** is a schematic cross-sectional view of an electron-optical device featuring optical fibers outside the electron-optical column.
**FIG. 20** is a schematic plan view of the arrangement of **FIG. 19****.**

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical system, it is appreciated that the embodiments are not used to limit the present disclosure to specific charged particles. References to electrons throughout the present document may therefore be more generally considered to be references to charged particles, with the charged particles not necessarily being electrons. For example, reference to an electron-optical apparatus may be more generally considered to be reference to a charged particle apparatus.

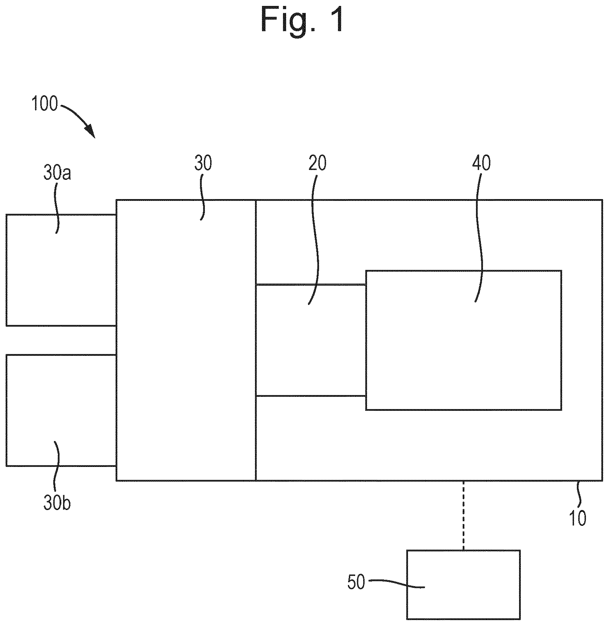

Reference is now made to **FIG. 1****,** which is a schematic diagram illustrating an exemplary electron beam inspection apparatus 100. The electron beam inspection apparatus 100 of **FIG. 1** includes a main chamber 10, a load lock chamber 20, an electron-optical apparatus 40 (which may also be called an electron assessment apparatus or an electron beam system or tool), an equipment front end module (EFEM) 30 and a controller 50. The electron-optical apparatus 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the electron-optical apparatus 40 by which it may be inspected. The electron-optical apparatus 40 comprises an electron-optical device 41 (which may be referred to as a charged particle device). The electron-optical device 41 may be an electron-optical column configured to project at least one electron beam towards the sample 208, and/or an objective lens module configured to focus at least one electron beam onto the sample 208. The electron-optical device 41 may also comprise a detector module configured to detect electrons emitted from the sample 208, and/or a control lens module configured to adjust an electron-optical parameter of at least one electron beam. In an embodiment the electron-optical column may comprise the objective lens module and the detector module and optionally the control lens module. In an embodiment the electron-optical device comprises an objective lens assembly which may be comprised in the electron-optical column. The objective lens assembly comprises an objective lens array associated with (e.g. integrated with) one or more other electron-optical components such as a detector array and optionally a control lens array. The electron-optical device 41 may be a multi-beam electron-optical device 41 for a multi-beam projected towards the sample 208. In an embodiment the electron-optical device 41 comprises multi-devices (or columns) comprising a plurality of electron-optical devices configured to project respective electron beam or electron multi-beams towards the sample 208.

The controller 50 is electronically connected to electron-optical components of the electron-optical device 41 of the electron-optical apparatus 40. The controller 50 may be a processor (such as a computer) configured to control the electron beam inspection apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the electron beam inspection apparatus 100 or it can be distributed over at least two of the component elements. The controller may be considered to be part of the electron-optical device 41. While the present disclosure provides examples of the main chamber 10 housing an electron beam inspection tool, it should be noted that aspects of the disclosure in their broadest sense are not limited to a chamber housing an electron beam inspection tool. Rather, it is appreciated that the foregoing principles may also be applied to other tools and other arrangements of apparatus, that operate under the second pressure.

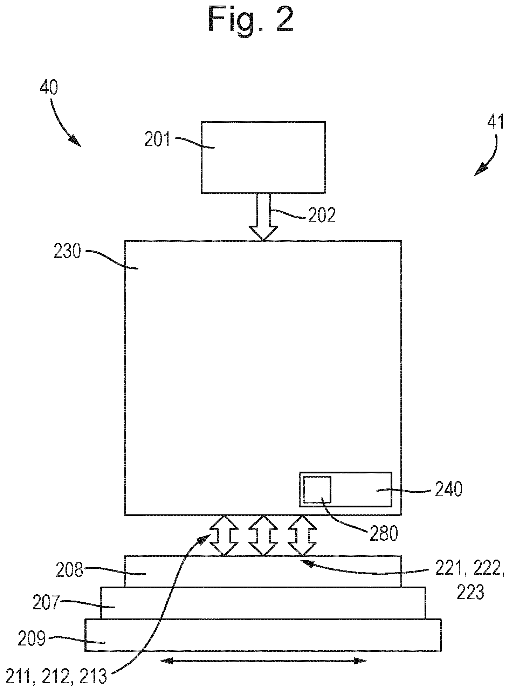

Reference is now made to **FIG. 2****,** which is a schematic diagram illustrating an exemplary electron-optical apparatus 40 including a multi-beam electron-optical device 41 that is part of the exemplary electron beam inspection apparatus 100 of **FIG. 1****.** The multi-beam electron-optical device 41 comprises an electron source 201 and a projection apparatus 230. The electron-optical apparatus 40 further comprises a motorized stage 209 and a sample holder 207. The projection apparatus 230 may be referred to as the electron-optical device 41. The sample holder 207 is supported by motorized stage 209 so as to hold a sample 208 (e.g., a substrate or a mask) for inspection. The multi-beam electron-optical device 41 may further comprise a detector 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary assessment electron beam 202. The electron source 201 may comprise multiple sources, such as described in EP20184161.6, which is hereby incorporated by reference at least with respect to the multiple sources and how they relate to multiple columns and their associated electron-optics.

The projection apparatus 230 is configured to convert the primary assessment electron beam 202 into a plurality of assessment sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

The controller 50 may be connected to various parts of the electron beam inspection apparatus 100 of **FIG. 1****.** The controller 50 may be connected to various parts of the electron-optical apparatus 40 of **FIG. 2****,** such as the electron source 201, the detector 240, the projection apparatus 230, and the motorized stage 209 (or actuated stage). The controller 50 may perform various data, image and/or signal processing functions. The controller 50 may also generate various control signals to govern operations of the electron beam inspection apparatus 100, including the multi-beam electron-optical apparatus 40.

The projection apparatus 230 may be configured to focus assessment sub-beams 211, 212, and 213 onto a sample 208 for inspection and may form three probe spots 221, 222, and 223 on the surface of sample 208. The projection apparatus 230 may be configured to deflect the assessment sub-beams 211, 212, and 213 to scan the probe spots 221, 222, and 223 across individual scanning areas in a section of the surface of the sample 208. In response to incidence of the assessment sub-beams 211, 212, and 213 on the probe spots 221, 222, and 223 on the sample 208, signal charged particles (e.g. signal electrons) are generated (i.e. emitted) from the sample 208 which include secondary signal particles and backscatter signal particles. The signal particles emitted from the sample, e.g. secondary electrons and backscatter electrons, may otherwise be referred to as charged particles, e.g. secondary charged particles and backscatter charged particles. Signal beams are formed of signal particles emitted from the sample. It will generally be understood that any signal beams emitted from the sample 208 will travel in a direction with at least a component substantially opposite to the charged particle beams (i.e. the primary beams), or will have at least a component of direction which is opposite to the direction of the primary beams. Signal particles, which are emitted by the sample 208 may also pass through the electrodes of the objective lens and would also be affected by the field.

The secondary electrons typically have electron energy < 50 eV. Actual secondary electrons can have an energy of less than 5 eV, but anything beneath 50 eV is generally treated at a secondary electron. Backscatter electrons typically have electron energy between 0 eV and the landing energy of the assessment sub-beams 211, 212, and 213. As electrons detected with an energy of less than 50 eV is generally treated as a secondary electron, a proportion of the actual backscatter electrons will be counted as secondary electrons. The secondary signal particles may more specifically be referred to, and are interchangeable with, secondary electrons. The backscatter signal particles may more specifically be referred to, and are interchangeable with, backscatter electrons. The skilled person would understand that the backscatter signal particles may more generally be described as secondary signal particles. However, for the purposes of the present disclosure, the backscatter signal particles are considered to be different from the secondary signal particles, e.g. having higher energies. In other words, the secondary signal particles will be understood to be particles having kinetic energy < 50 eV when emitted from the sampled and the backscatter signal particles will be understood to be particles having kinetic energy higher than 50 eV when emitted from the sample. In practice, the signal particles may be accelerated before being detected and thus, the energy range associated with the signal particles may be slightly higher. For example, the secondary signal particles will be understood to be particles having kinetic energy < 200 eV when detected at a detector and the backscatter signal particles will be understood to be particles having kinetic energy higher than 200 eV when detected at a detector. It is noted that the 200 eV value may vary depending on the extent of acceleration of the particles, and may for example be approximately 100 eV or 300 eV. Secondary signal particles having such values are still considered to have sufficient energy different with respect to the backscatter signal particles.

The detector 240 is configured to detect (e.g. capture) signal particles such as secondary electrons and/or backscatter electrons and to generate corresponding signals which are sent to a signal processing system 280, e.g. to construct images of the corresponding scanned areas of sample 208. The detector 240 may be incorporated into the projection apparatus 230. The detector array may otherwise be referred to as a sensor array, and the terms "detector" and "sensor" and "sensor unit" are used interchangeably throughout the application.

The signal processing system 280 may comprise a circuit (not shown) configured to process signals from the detector 240 so as to form an image. The signal processing system 280 could otherwise be referred to as an image processing system. The signal processing system may be incorporated into a component of the multi-beam electron-optical apparatus 40 such as the detector 240 (as shown in **FIG. 2**). However, the signal processing system 280 may be incorporated into any components of the electron beam inspection apparatus 100 or multi-beam electron-optical apparatus 40, such as, as part of the projection apparatus 230 or the controller 50. The signal processing system 280 could be located outside of the structure that includes the main chamber which is shown in **FIG. 1****.** The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive a signal from the detector 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary electrons. The electron distribution data, collected during a detection time window, can be used in combination with corresponding scan path data of each of assessment sub-beams 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample.

The controller 50 may control the motorized stage 209 to move sample 208 during inspection of the sample 208. The controller 50 may enable the motorized stage 209 to move the sample 208 in a direction, preferably continuously, for example at a constant speed, at least during sample inspection. The controller 50 may control movement of the motorized stage 209 so that it changes the speed of the movement of the sample 208 dependent on various parameters. For example, the controller 50 may control the stage speed (including its direction) depending on the characteristics of the inspection steps of scanning process.

Known multi-beam systems, such as the electron-optical apparatus 40 and electron beam inspection apparatus 100 described above, are disclosed in US2020118784, US20200203116, US 2019/0259570 and US2019/0259564 which are hereby incorporated by reference.

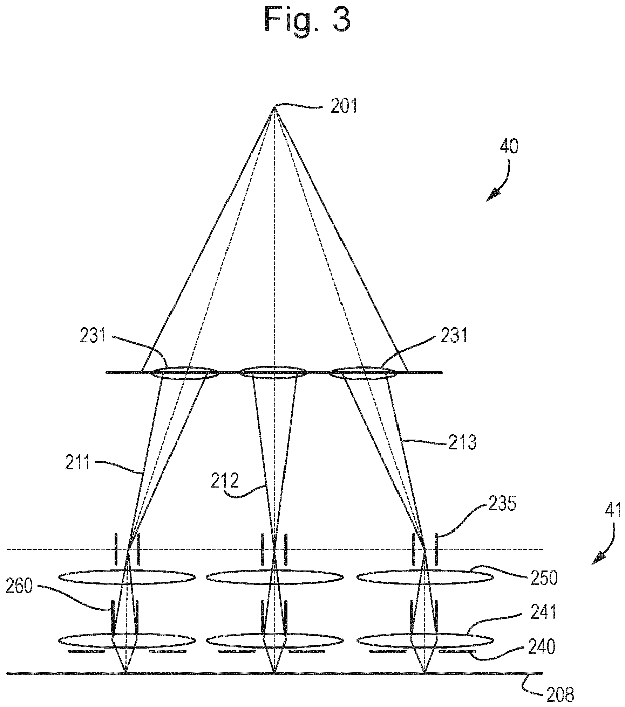

Components of an electron-optical apparatus 40 which may be used in the present invention are described below in relation to **FIG. 3** which is a schematic diagram of an electron-optical apparatus 40. The electron-optical apparatus 40 of **FIG. 3** may correspond to the electron-optical apparatus 40 (which may also be referred to as a system or a tool) mentioned above.

The electron source 201 directs electrons toward an array of condenser lenses 231 (otherwise referred to as a condenser lens array). The electron source 201 is desirably a high brightness thermal field emitter with a good compromise between brightness and total emission current. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an electron beam, for example from the source, into a plurality of sub-beams, with the array providing a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect. More generally, the condenser lenses 231 may have two or more plate electrodes each with an array of apertures that are aligned. Each plate electrode array is mechanically connected to, and electrically isolated from, an adjacent plate electrode array by an isolating element, such as a spacer which may comprise ceramic or glass. The condenser lenses may be connected and/or spaced apart from an adjacent charged particle-optical element, preferably an electrostatic charged particle-optical element, by an isolating element such as a spacer as described elsewhere herein.

The condenser lenses may be separated from a module containing the objective lenses (such as an objective lens array assembly as discussed elsewhere herein). In a case where the potential applied on a bottom surface of the condenser lenses is different than the potential applied on the top surface of the module containing the objective lenses an isolating element (e.g. a spacer) is used to space apart the condenser lenses and the module containing the objective lenses. In a case where the potential is equal then a conductive element can be used to space apart the condenser lenses and the module containing the objective lenses.

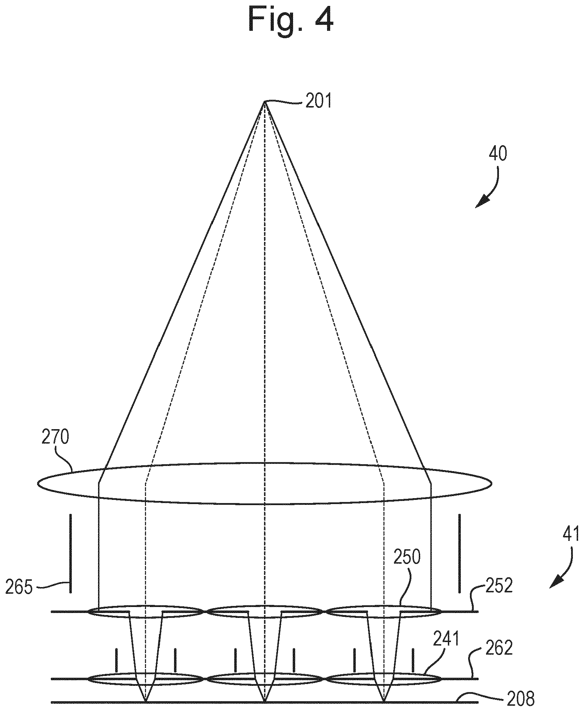

Each condenser lens 231 in the array directs electrons into a respective assessment sub-beam 211, 212, 213 which is focused at a respective intermediate focus down-beam of the condenser lens array. The respective sub-beams are projected along respective sub-beam paths 220. The sub-beams diverge with respect to each other. The sub-beam paths 220 diverge down-beam of the condenser lenses 231. In an embodiment, deflectors 235 are provided at the intermediate focuses. The deflectors 235 are positioned in the sub-beam paths at, or at least around, the position of the corresponding intermediate focuses or focus points (i.e. points of focus). The deflectors 235 are positioned in or close to the sub-beam paths at the intermediate image plane of the associated sub-beam. The deflectors 235 are configured to operate on the respective assessment sub-beams 211, 212, 213. The deflectors 235 are configured to bend a respective assessment sub-beam 211, 212, 213 by an amount effective to ensure that the principal ray (which may also be referred to as the beam axis) is incident on the sample 208 substantially normally (i.e. at substantially 90° to the nominal surface of the sample). The deflectors 235 may also be referred to as collimators or collimator deflectors. The deflectors 235 in effect collimate the paths of the sub-beams so that before the deflectors, the sub-beam paths with respect to each other are diverging. Down-beam of the deflectors the sub-beam paths are substantially parallel with respect to each other, i.e. substantially collimated. Suitable collimators are deflectors disclosed in EP Application 20156253.5 filed on 7 February 2020 which is hereby incorporated by reference with respect to the application of the deflectors to a multi-beam array. The collimator may comprise a macro collimator 270 (e.g. as shown in **FIG. 4**), instead of, or in addition to the deflectors 235. Thus, the macro-collimator 270 described below in relation to **FIG. 4** may be provided with the features of **FIG. 3****.** This is generally less preferred than providing the collimator array as deflectors 235.

Below (i.e. down-beam or further from electron source 201) the deflectors 235 there is a control lens array 250. The assessment sub-beams 211, 212, 213 having passed through the deflectors 235 are substantially parallel on entry to the control lens array 250. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations.

In further detail, it is desirable to use the control lens array 250 to determine the landing energy. However, it is possible to use in addition the objective lens array 241 to control the landing energy. In such a case, a potential difference over the objective lens is changed when a different landing energy is selected. One example of a situation where it is desirable to partly change the landing energy by changing the potential difference over the objective lens is to prevent the focus of the sub-beams getting too close to the objective lenses. In such a situation there is a risk of components of the objective lens array 241 having to be too thin to be manufacturable. The same may be said about a detector at this location, for example in, on or otherwise associated with the objective lens. This situation can for example occur in case the landing energy is lowered. This is because the focal length of the objective lens roughly scales with the landing energy used. By lowering the potential difference over the objective lens, and thereby lowering the electric field inside the objective lens, the focal length of the objective lens is made larger again, resulting in a focus position further below the objective lens. Note that use of just an objective lens would limit control of magnification. Such an arrangement could not control demagnification and/or opening angle. Further, using the objective lens to control the landing energy could mean that the objective lens would be operating away from its optimal field strength. That is unless mechanical parameters of the objective lens (such as the spacing between its electrodes) could be adjusted, for example by exchanging the objective lens.

The control lens array 250 comprises a plurality of control lenses. Each control lens comprises at least one electrode, preferably two electrodes (e.g. two or three electrodes) connected to respective potential sources. The control lens array 250 may comprise one or more (e.g. three) plate electrode arrays connected to respective potential sources. The control lens array electrodes may be spaced a few millimeters (e.g. 3mm) apart. The control lens array 250 is associated with the objective lens array 241 (e.g. the two arrays are positioned close to each other and/or mechanically connected to each other and/or controlled together as a unit). Each control lens may be associated with a respective objective lens. The control lens array 250 is positioned up-beam of the objective lens array 241. Up-beam may be defined as being closer to the source 201. Up-beam may otherwise be defined as further from the sample 208. The control lens array 250 may be in the same module as an objective lens array 241, i.e. forming an objective lens array assembly or objective lens arrangement, or it may be in a separate module. In this case, the arrangement may be described as four or more lens electrodes that are plates. In the plates are defined apertures, for example as aperture arrays, that are aligned with a number of sub-beams in a corresponding beam array. The electrodes may be grouped into two or more electrodes, for example to provide a control electrode group, and an objective electrode group. In an arrangement the objective electrode group has at least three electrodes and the control electrode group has at least two electrodes. Alternatively, if the control lens array 250 and the objective lens array 240 are separate, the spacing between the control lens array 241 and the objective lens array 250 (i.e. the gap between lower electrode of the control lens array 250 and the upper electrode of the objective lens 241) can be selected from a wide range, e.g. from 2 mm to 200 mm or more. A small separation makes alignment easier whereas a larger separation allows a weaker lens to be used, reducing aberrations.

Each plate electrode of the control lens array 250 is preferably mechanically connected to, and electrically separated from, an adjacent plate electrode array by an isolating element, such as a spacer which may comprise ceramic or glass. Each plate electrode of the objective lens array is preferably mechanically connected to, and electrically separated from, an adjacent plate electrode array by an isolating element, such as a spacer which may comprise ceramic or glass. The isolating element may otherwise be referred to as an insulating structure, and may be provided to separate any adjacent electrodes provided, such as in the objective lens array 240, the condenser lens array (as depicted in **FIG. 3**) and/or the control lens array 250. If more than two electrodes are provided, multiple isolating elements (i.e. insulating structures) may be provided. For example, there may be a sequence of insulating structures.

The control lens array 250 may be considered as one or more electrodes additional to the electrodes of the objective lens array 241. The control lens array 250 provides extra degrees of freedom for controlling the sub-beams. A greater number of electrodes comprised in the control lens array 250 provides a greater number of degrees of freedom. For example, these extra electrodes may permit landing energy and/or magnification control independent of the field strength of the objective lens array 241. In some designs the control lens may thus be part of the objective lens. Reference to such electrodes may thus be as part of the objective lens rather than a separate lens such as a control lens. Reference to a control lens in such an arrangement is reference to functionally equivalent electrodes of the objective lens.

The control lens array 250 comprises a control lens for each assessment sub-beam 211, 212, 213. A control lens adds optical degrees of freedom to the function of the associated objective lens. A control lens may comprise of one or more electrode or plates. The addition of each electrode may provide a further degree of freedom of the control of the charged particle-optical function of the associated objective lens. In an arrangement the function of the control lens array 250 is to optimize the beam opening angle with respect to the demagnification of the beam and/or to control the beam energy delivered to the objective lenses, each of which directs a respective assessment sub-beam 211, 212, 213 onto the sample 208. The objective lens array 241 may be positioned at or near the base of the electron-optical system 41. More specifically, the objective lens array may be positioned at or near the base of the projection system 230. The control lens array 250 is optional, but is preferred for optimizing a sub-beam up-beam of the objective lens array 241.

For ease of illustration, lens arrays are depicted schematically herein by arrays of oval shapes (as shown in **FIG. 3**). Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. Lens arrays may instead comprise multiple plates with apertures.

Optionally, an array of scan deflectors 260 is provided between the control lens array 250 and the array of objective lenses 234. The array of scan deflectors 260 comprises a scan deflector for each assessment sub-beam 211, 212, 213. Each scan deflector is configured to deflect a respective assessment sub-beam 211, 212, 213 in one or two directions so as to scan the sub beam across the sample 208 in one or two directions.

**FIG. 4** is a schematic diagram of an exemplary electron-optical apparatus 40 comprising a macro collimator 270 and macro scan deflector 265. The electron source 201 directs electrodes toward a macro collimator 270. The electron source 201 is desirably a high brightness thermal field emitter with a good compromise between brightness and total emission current.

Sub-beams may be derived from the beam, for example, using a sub-beam forming array 252 (also known as a beam limiting aperture array) defining an array of beam-limiting apertures. The beam may separate into the sub-beams on meeting the control lens array 250, described below. The sub-beams are substantially parallel on entry to the control lens array 250.

The macro collimator 270 acts on the beam from the source 201 before the beam has been split into a multi-beam. The macro collimator 270 bends respective portions of the beam by an amount effective to ensure that a beam axis of each of the sub-beams derived from the beam is incident on the sample 208 substantially normally (i.e. at substantially 90° to the nominal surface of the sample 208). Thus the path of each sub-beam is at least intended to be orthogonal to the surface of the sample 208. The macro collimator 270 applies a macroscopic collimation to the beam. The macro collimator 270 may thus act on all of the beam rather than comprising an array of collimator elements that are each configured to act on a different individual portion of the beam. The macro collimator 270 may comprise a magnetic lens or magnetic lens arrangement comprising a plurality of magnetic lens sub-units (e.g. a plurality of electromagnets forming a multi-pole arrangement). Alternatively or additionally, the macro-collimator may be at least partially implemented electrostatically. The macro-collimator may comprise an electrostatic lens or electrostatic lens arrangement comprising a plurality of electrostatic lens sub-units. The macro collimator 270 may use a combination of magnetic and electrostatic lenses.

In another arrangement (not shown), the macro collimator 270 may be partially or wholly replaced by a collimator element array provided down-beam of the sub-beam forming array. Each collimator element collimates a respective sub-beam. The collimator element array may be formed using MEMS manufacturing techniques so as to be spatially compact. The collimator element array may be the first deflecting or focusing electron-optical array element in the beam path down-beam of the source 201. The collimator element array may be up-beam of the control lens array 250. The collimator element array may be in the same module as the control lens array 250.

As shown in **FIG. 4****,** in an embodiment the electron-optical device 41 comprises an objective lens array 241. The objective lens array 241 comprises a plurality of objective lenses. The objective lens array 241 may be an exchangeable module. The exchangeable module may feature other electron-optical elements such as a detector array and/or a control lens array.

Below (i.e. down-beam or further from the electron source 201) the macro collimator 270 there is a control lens array 250. The control lens array 250 is configured to apply a focusing action to the sub-beams prior to the sub-beams reaching the objective lens array. The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations. Additionally or alternatively, the control lenses in the control lens array 250 are configured to control the opening angle of the sub-beams and/or to control demagnification (i.e. magnification) of the sub-beams and/or to control landing energy.

The control lens array 250 may be as described above in relation to **FIG. 3****.** The control lens array 250 may be considered as one or more electrodes additional to the electrodes of the objective lens array 241. The control lens array 250 provides extra degrees of freedom for controlling the sub-beams. A greater number of electrodes comprised in the control lens array 250 provides a greater number of degrees of freedom. For example, these extra electrodes may permit landing energy and/or magnification control independent of the field strength of the objective lens array 241. In some designs the control lens may thus be part of the objective lens. Reference to such electrodes may thus be as part of the objective lens rather than a separate lens such as a control lens.

The control lens array 250 comprises a control lens for each assessment sub-beam 211, 212, 213. A function of the control lens array 250 is to optimize the beam opening angle with respect to the demagnification of the beam and/or to control the beam energy delivered to the objective lens array 241 which directs the assessment sub-beams 211, 212, 213 onto the sample 208. The objective lens array 241 may be positioned at or near the base of the electron-optical device 41. The control lens array 250 is preferred for optimizing a sub-beam up-beam of the objective lens array 241.

In the embodiment of **FIG. 4** a macro scan deflector 265 is provided to cause sub-beams to be scanned over the sample 208. The macro scan deflector 265 deflects respective portions of the beam to cause the sub-beams to be scanned over the sample 208. In an embodiment, the macro scan deflector 265 comprises a macroscopic multi-pole deflector, for example with eight poles or more. The deflection is such as to cause sub-beams derived from the beam to be scanned across the sample 208 in one direction (e.g. parallel to a single axis, such as an X axis) or in two directions (e.g. relative to two non-parallel axes, such as X and Y axes). The macro scan deflector 265 acts macroscopically on all of the beam rather than comprising an array of deflector elements that are each configured to act on a different individual portion of the beam. In the embodiment shown, the macro scan deflector 265 is provided between the macro collimator 270 and the control lens array 250.

In another arrangement (not shown), the macro scan deflector 265 may be partially or wholly replaced by a scan deflector array. The scan deflector array comprises a plurality of scan deflectors. The scan deflector array may be formed using MEMS manufacturing techniques. Each scan deflector scans a respective sub-beam over the sample 208. The scan-deflector array may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). The scan deflector array may be up-beam of an objective lens array 241. The scan deflector array may be down-beam of a control lens array 250. Although reference is made to a single sub-beam associated with a scan deflector, groups of sub-beams may be associated with a scan deflector. In an embodiment, the scanning deflectors described in EP2425444, which document is hereby incorporated by reference in its entirety specifically in relation to scan deflectors, may be used to implement the scan-deflector array. A scan-deflector array (e.g. formed using MEMS manufacturing techniques as mentioned above) may be more spatially compact than a macro scan deflector. The scan deflector array may be in the same module as the objective lens array 241.

In other embodiments both a macro scan deflector 265 and the scan-deflector array are provided. In such an arrangement, the scanning of the sub-beams over the sample surface may be achieved by controlling the macro scan deflector and the scan-deflector array together, preferably in synchronization.

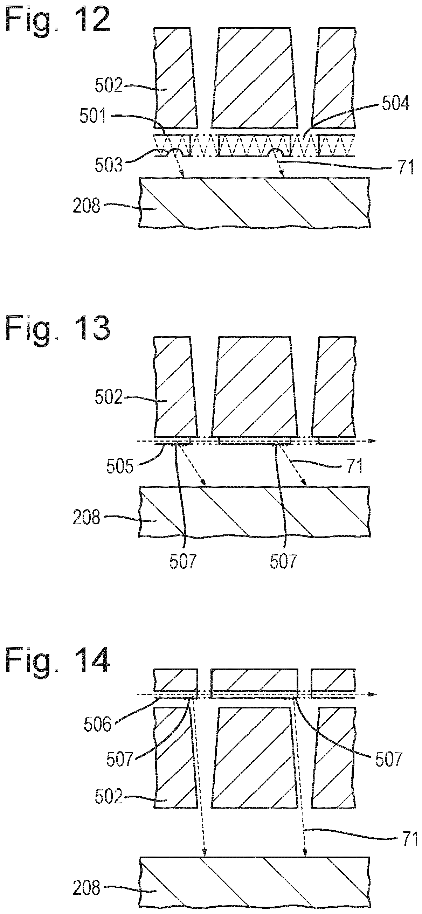

In some embodiments, the electron-optical device 41 further comprises a sub-beam forming array 252. The sub-beam forming array 252 defines an array of beam-limiting apertures. The sub-beam forming array 252 may be referred to as an upper beam-limiting aperture array or up-beam beam-limiting aperture array. The sub-beam forming array 252 may comprise a plate (which may be a plate-like body) having a plurality of apertures. The sub-beam forming array 252 forms sub-beams from a beam of electrons emitted by the source 201. Portions of the beam other than those contributing to forming the sub-beams may be blocked (e.g. absorbed) by the sub-beam forming array 252 so as not to interfere with the sub-beams down-beam. The sub-beam forming array 252 may be referred to as a sub-beam defining aperture array or an upper beam limiter. The apertures of the sub-beam forming array 252 may have a diameter 72 (see **FIG. 12**) of at least 20 µm, optionally at least 50 µm, optionally at least 100 µm, and optionally 120 µm. The apertures have a pitch that may by equal to that of the apertures of the beam apertures 406.

In some embodiments, as exemplified in **FIG. 4****,** the electron-optical device 41 is an objective lens array assembly (which is a unit that comprises the objective lens array 241) and comprises a beam shaping aperture array 262. The beam shaping aperture array 262 defines an array of beam-limiting apertures. The beam shaping aperture array 262 may be referred to as a lower beam limiter, lower beam-limiting aperture array or final beam-limiting aperture array. The beam shaping aperture array 262 may comprise a plate (which may be a plate-like body) having a plurality of apertures. The beam shaping aperture array 262 may be down-beam from at least one electrode (optionally from all electrodes) of the control lens array 250. In some embodiments, the beam shaping aperture array 262 is down-beam from at least one electrode (optionally from all electrodes) of the objective lens array 241.

In an arrangement, the beam shaping aperture array 262 is structurally integrated with an electrode of the objective lens array 241. Desirably, the beam shaping aperture array 262 is positioned in a region of low electrostatic field strength. Each of the beam-limiting apertures is aligned with a corresponding objective lens in the objective lens array 241. The alignment is such that a portion of a sub-beam from the corresponding objective lens can pass through the beam-limiting aperture and impinge onto the sample 208. Each beam-limiting aperture has a beam limiting effect, allowing only a selected portion of the sub-beam incident onto the beam shaping aperture array 262 to pass through the beam-limiting aperture. The selected portion may be such that only a portion of the respective sub-beam passing through a central portion of respective apertures in the objective lens array reaches the sample. The central portion may have a circular cross-section and/or be centered on a beam axis of the sub-beam.

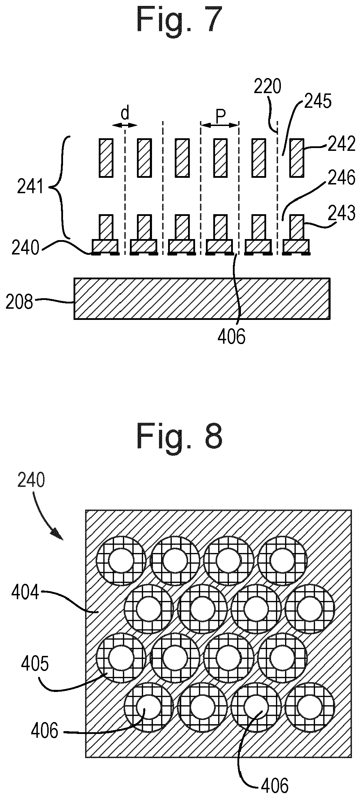

Any of the electron-optical apparatuses 40 described herein may further comprise a detector 240. The detector 240 detects signal particles, such as electrons, emitted from the sample 208. The detected electrons may include any of the electrons detected by an SEM, including secondary and/or backscatter electrons emitted from the sample 208. An exemplary construction of a detector 240 is shown in **FIG. 7** and described in more detail below with reference to **FIGs. 8-10****.**

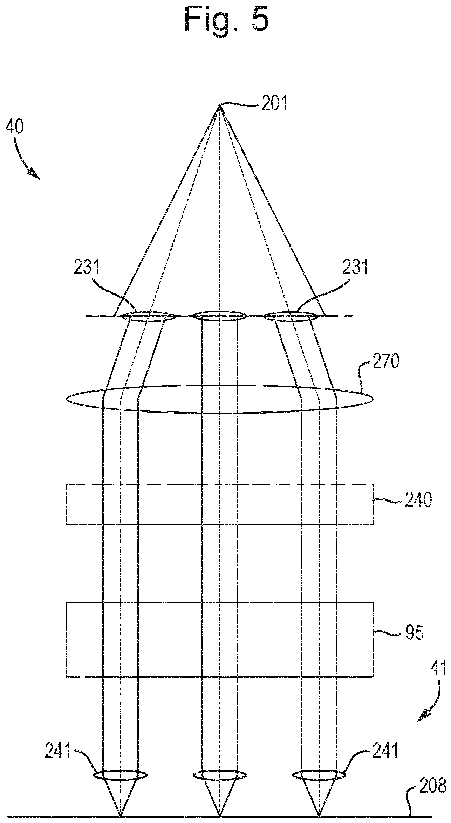

**FIG. 5** schematically depicts an electron-optical apparatus 40 according to an embodiment. Features that are the same as those described above are given the same reference numerals. For conciseness, such features are not described in detail with reference to **FIG. 5****.** For example, the source 201, the macro collimator 270, the objective lens array 241 and the sample 208 may be as described above.

In an embodiment the electron-optical apparatus 40 comprises an array condenser lenses 231. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which electrons have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

As described above, in an embodiment the detector 240 is between the objective lens array 241 and the sample 208. The detector 240 may face the sample 208. Alternatively, as shown in **FIG. 5****,** in an embodiment the objective lens array 241, which comprises the plurality of objective lenses, is between the detector 240 and the sample 208.

In an embodiment a deflector array 95 is between the detector 240 and the objective lens array 241. In an embodiment the deflector array 95 comprises a Wien filter so that deflector array may be referred to as a beam separator. The deflector array 95 is configured to provide a magnetic field to disentangle the electrons projected to the sample 208 from the secondary electrons from the sample 208.

In an embodiment the detector 240 is configured to detect signal particles by reference to the energy of the electron, i.e. dependent on a band gap. Such a detector 240 may be called an indirect current detector. The secondary electrons emitted from the sample 208 gain energy from the fields between the electrodes. The secondary electrodes have sufficient energy once they reach the detector 240.

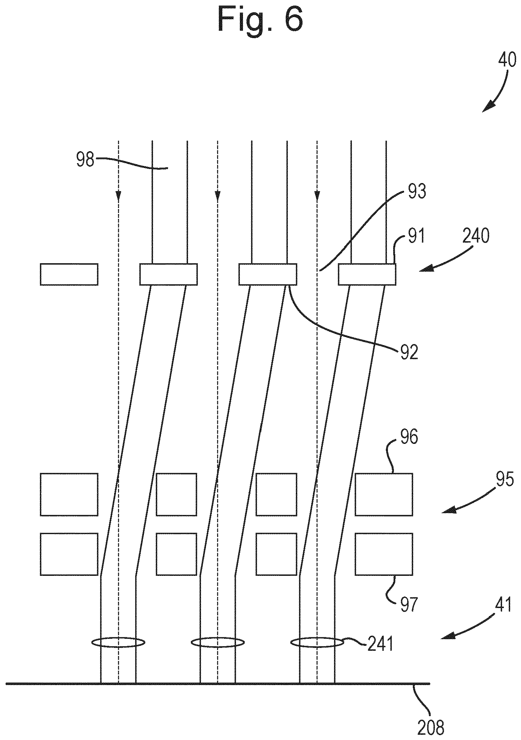

**FIG. 6** is a close-up view of part of the electron-optical apparatus 40 shown in **FIG. 5****.** In an embodiment the detector 240 comprises an electron to photon converter array 91. The electron to photon converter array 91 comprises a plurality of fluorescent strips 92. Each fluorescent strip 92 is located in the plane of the electron to photon converter array 91. At least one fluorescent strip 92 is arranged between two adjacent electron beams projected towards the sample 208.

In an embodiment, the fluorescent strips 92 extend substantially in the horizontal direction. Alternatively, the electron to photon converter array 91 may comprise a plate of a fluorescent material with openings 93 for the projected electron beams.

The projected electron beams, indicated by dashed lines in **FIG. 6****,** are projected through the plane of the electron to photon converter array 91, via the openings 93 between the fluorescent strips 92, towards the deflector array 95.

In an embodiment the deflector array 95 comprises a magnetic deflector 96 and an electrostatic deflector 97. The electrostatic deflector 97 is configured to counteract the deflection of the magnetic deflector 96 for the projected electron beams transmitted towards the sample 208. Accordingly, the projected electron beams may be shifted to a small extent in the horizontal plane. The beams down-beam of the deflector array 95 are substantially parallel to the beams up-beam of the deflector array 95.

In an embodiment the objective lens array 241 comprises a plurality of plates for guiding secondary electrons created in the sample 208 towards the deflector array 95. For the secondary electrons, which travel in opposite direction with respect to the projected electron beams, the electrostatic deflector 97 does not counteract the deflection of the magnetic deflector 96. Instead, the deflections of the secondary electrons by the electrostatic deflector 97 and the magnetic deflector 96 add up. Accordingly, the secondary electrons are deflected to travel at an angle with respect to the optical axis in order to transmit the secondary electrons onto the fluorescent strips 92 of the detector 240.

At the fluorescent strips 92, photons are created upon incidence of the secondary electrons. In an embodiment, the photons are transported from the fluorescent strip 92 to a photo detector (not shown) via a photon transport unit. In an embodiment, the photon transport unit comprises an array of optical fibers 98. Each optical fiber 98 comprises an end which is arranged adjacent or attached to one of the fluorescent strips 92 for coupling photons from the fluorescent strip 92 into the optical fiber 98, and another end which is arranged to project photons from the optical fiber 98 onto the photo detector.

The objective lens array 241 of any embodiment may comprise at least two electrodes in which are defined aperture arrays. In other words, the objective lens array comprises at least two electrodes with a plurality of holes or apertures. Adjacent electrodes of the objective lens array 241 are spaced apart from each other along the sub-beam paths. The distance between adjacent electrodes along the beam path, in which an insulating structure might be positioned as described below, is smaller than the size of an objective lens (along the beam path, i.e. between the most up-beam and most down-beam electrode of the objective lens array). **FIG. 7** shows electrodes 242, 243 which are part of an exemplary objective lens array 241 having respective aperture arrays 245, 246. The position of each aperture in an electrode corresponds to the position of a corresponding aperture in another electrode. The corresponding apertures operate in use on the same beam, sub-beam or group of beams in the multi-beam. In other words, corresponding apertures in the at least two electrodes are aligned with and arranged along a sub-beam path, i.e. one of the sub-beam paths 220. Thus, the electrodes are each provided with apertures through which the respective assessment sub-beam 211, 212, 213 propagates.

The aperture arrays 245, 246 of the objective lens array 241 may consist of a plurality of apertures, preferably with substantially uniform diameters, d. However there may be some variation for optimizing aberration correction as described in EP Application 20207178.3 filed on 12 November 2020 which is herein incorporated by reference at least with respect to corrections achieved by varying aperture diameter. The diameter, d, of the apertures in at least one electrode may be less than approximately 400 µm. Preferably, the diameter, d, of the apertures in at least one electrode is between approximately 30 to 300 µm. Smaller aperture diameters may provide larger detectors of the detector array 240 for a given aperture pitch, improving the chance of capturing backscatter signal particles. Thus the signal for the backscatter signal particles may improve. However, having apertures that are too small risk inducing aberrations in the primary sub-beams. The plurality of apertures in an electrode may be spaced apart from each other by a pitch, P. The pitch, P, is defined as the distance from the middle of one aperture to the middle of an adjacent aperture. The pitch between adjacent apertures in at least one electrode may be less than approximately 600 µm. Preferably, the pitch between adjacent apertures in at least one electrode is between approximately 50 µm and 500 µm. Preferably, the pitch between adjacent apertures on each electrode is substantially uniform. The values for the diameter and/or pitch described above can be provided in at least one electrode, multiple electrodes, or all electrodes in an objective lens array. Preferably, the dimensions referred to and described apply to all electrodes provided in an array of objective lenses.

The objective lens array 241 may comprise two electrodes, as shown in **FIG. 7****,** or three electrodes, or may have more electrodes (not shown). An objective lens array 241 having only two electrodes can have fewer aberrations, e.g. a lower aberration risk and/or impact, than an objective lens array 241 having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam. Such additional electrodes may be considered to form the control lens array 250. A benefit of two electrode lens over an Einzel lens is that the energy of an in-coming beam is not necessarily the same as an out-going beam. Beneficially the potential differences on such a two electrode lens array enables it to function as either an accelerating or a decelerating lens array.

Adjacent electrodes of the objective lens array 241 are spaced apart from each other along the sub-beam paths. The distance between adjacent electrodes, in which an insulating structure might be positioned as described below, is larger than the objective lens. The objective lens array 241 can be configured to demagnify the charged particle beam by a factor greater than 10, desirably in the range of 50 to 100 or more. Each element in the objective lens array 240 may be a micro-lens operating a different sub-beam or group of sub-beams in the multi-beam.

Preferably, each of the electrodes provided in the objective lens array 241 is a plate. The electrode may otherwise be described as a flat sheet. Preferably, each of the electrodes is planar. In other words, each of the electrodes will preferably be provided as a thin, flat plate, in the form of a plane. Of course, the electrodes are not required to be planar. For example, the electrode may bow due to the force due to the high electrostatic field. It is preferable to provide a planar electrode because this makes manufacturing of the electrodes easier as known fabrication methods can be used. Planar electrodes may also be preferable as they may provide more accurate alignment of apertures between different electrodes.

The objective lens array 241 can be configured to demagnify the electron beam by a factor greater than 10, desirably in the range of 50 to 100 or more.

A detector 240 is provided to detect secondary and/or backscatter electrons emitted from the sample 208. The detector 240 is positioned between the objective lenses 234 and the sample 208. The detector 240 may otherwise be referred to as a detector array or a sensor array, and the terms "detector" and "sensor" are used interchangeably throughout the application.

In an embodiment the electron-optical device 41 is configured to project a beam of electrons towards the sample 208. The electron-optical device 41 may comprise the objective lens array 241. The electron-optical device 41 may comprise the detector 240. The array of objective lenses (i.e. the objective lens array 241) may correspond with the array of detectors (i.e. the detector 240) and/or any of the beams (i.e. the sub-beams).

An exemplary detector 240 is described below. However, any reference to the detector 240 could be a single detector (i.e. at least one detector) or multiple detectors as appropriate. The detector 240 may comprise detector elements 405 (e.g. sensor elements such as capture electrodes). The detector 240 may comprise any appropriate type of detector. For example, capture electrodes for example to detect directly electron charge, scintillators or PIN elements can be used. The detector 240 may be a direct current detector or an indirect current detector. The detector 240 may be a detector as described below in relation to **FIGs. 8-10****.**

The detector 240 may be positioned between the objective lens array 241 and the sample 208. The detector 240 is configured to be proximate the sample 208. The detector 240 may be very close to the sample 208. Alternatively, there may be a larger gap between, the detector 240 and the sample 208. The detector 240 may be positioned in the device so as to face the sample 208. Alternatively, the detector 240 may be positioned elsewhere in the electron-optical device 41 such that part of the electron-optical device that faces the sample 208 is other than, and thus is not, a detector. For example the detector 240 may have a part at least associated with an electrode of the objective lens array 241.

For a multi-beam system of the type shown in **FIGs. 2-5****,** preferably, a distance between the electron-optical column and the sample 208 is less than or equal to approximately 50 µm. The distance is determined as the distance from a surface of the sample 208 facing the electron-optical column and a surface of the electron-optical column facing the sample 208.

**FIG. 8** is a bottom view of the detector 240 which comprises a substrate 404 on which are provided a plurality of detector elements 405 each surrounding a beam aperture 406. The beam apertures 406 may be formed by etching through the substrate 404. In the arrangement shown in **FIG. 8****,** the beam apertures 406 are in a hexagonal close packed array. The beam apertures 406 can also be differently arranged, e.g. in a rectangular array. The beam arrangement of the hexagonal arrangement in **FIG. 8** may be more densely packed than a square beam arrangement. The detector elements 405 may be arranged in a rectangular array or a hexagonal array.

In an embodiment the beam apertures 406 have a pitch P of at least 50 µm, optionally at least 100 µm, optionally at least 200 µm and optionally 210 µm. A greater pitch allows for the diameter d of the beam apertures 406 to be greater. In an embodiment the beam apertures 406 have a pitch P of at most 1000 µm, optionally at most 500 µm, and optionally at most 250 µm. The pitch of the beam apertures 406 defines the pitch of the sub-beams of the electron multi-beam that is projected toward the sample 208. In an embodiment the sub-beams of the electron multi-beam have a pitch of at least 50 µm, optionally at least 100 µm, optionally at least 200 µm and optionally 210 µm. In an embodiment the beam apertures 406 have a diameter d that is less than the pitch P. In an embodiment the beam apertures 406 have a diameter d that is at least 10 µm, and optionally at least 20 µm. In an embodiment the beam apertures 406 have a diameter d that is at most 100 µm, optionally at most 50 µm, and optionally at most 30 µm. A smaller diameter d improves the resolution such that smaller defects can be detected.

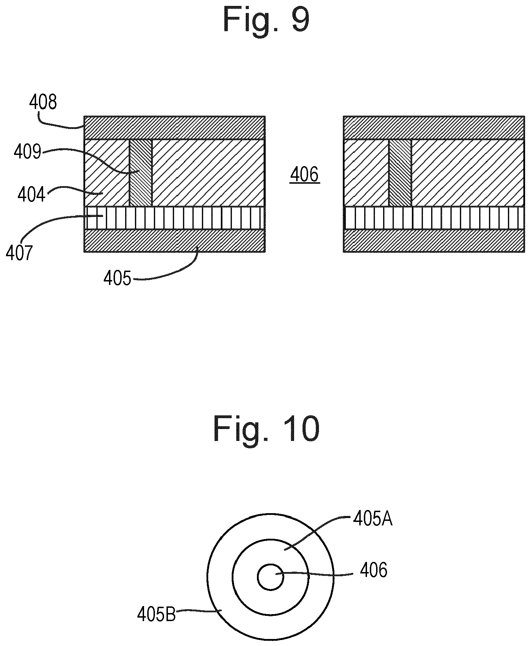

**FIG. 9** depicts at a larger scale a part of the detector 240 in cross section. The detector elements 405 form the bottommost, i.e. most close to the sample 208, surface of the detector 240. Between the detector elements 405 and the main body of the substrate 404 a logic layer 407 may be provided. At least part of the signal processing system may be incorporated into the logic layer 407.

A wiring layer 408 is provided on the backside of, or within, the substrate 404 and connected to the logic layer 407 by through-substrate vias 409. The number of through-substrate vias 409 need not be the same as the number of beam apertures 406. In particular if the electrode signals are digitized in the logic layer 407 only a small number of through-silicon vias may be required to provide a data bus. The wiring layer 408 can include control lines, data lines and power lines. It will be noted that in spite of the beam apertures 406 there is ample space for all necessary connections. The detection module 402 can also be fabricated using bipolar or other manufacturing techniques. A printed circuit board and/or other semiconductor chips may be provided on the backside of detector 240.

The integrated detector array described above is particularly advantageous when used with a tool having tunable landing energy as secondary electron capture can be optimized for a range of landing energies.

The detector 240 may be implemented by integrating a CMOS chip detector into a bottom electrode of the objective lens array 241. Integration of a detector 240 into the objective lens array 241 or other component of the electron-optical device 41 allows for the detection of electrons emitted in relation to multiple respective sub-beams. The CMOS chip is preferably orientated to face the sample (because of the small distance (e.g. 50 µm or less) between the sample and a bottom of the electron-optical column). In an embodiment, detector elements 405 to capture the secondary electrons are formed in the surface metal layer of the CMOS device. The detector elements 405 can be formed in other layers. Power and control signals of the CMOS may be connected to the CMOS by through-silicon vias. For robustness, preferably a passive silicon substrate with holes shields the CMOS chip from high E-fields.

In order to maximize the detection efficiency it is desirable to make the surface of the detector elements 405 as large as possible, so that substantially all the area of the objective lens array 240 (excepting the apertures) is occupied by detector elements 405. Additionally or alternatively, each detector element 405 has a diameter substantially equal to the array pitch (i.e. the aperture array pitch described above in relation to the electrodes of the objective lens assembly 241). Therefore, the diameter of each detector element may be less than approximately 600 µm, and preferably between approximately 50 µm and 500 µm. As described above, the pitch may be selected depending on the intended distance between the sample 208 and the detector 240. In an embodiment the outer shape of the detector element 405 is a circle, but this can be made a square to maximize the detection area. Also the diameter of the through-substrate via 409 can be minimized. A typical size of the electron beam is in the order of 5 to 15 micron.

In an embodiment, a single detector element 405 surrounds each beam aperture 406. In another embodiment, a plurality of detector elements 405 are provided around each beam aperture 406. The electrons captured by the detector elements 405 surrounding one beam aperture 406 may be combined into a single signal or used to generate independent signals. The detector elements 405 may be divided radially. The detector elements 405 may form a plurality of concentric annuluses or rings. The detector elements 405 may be divided angularly. The detector elements 405 may form a plurality of sector-like pieces or segments. The segments may be of similar angular size and/or similar area. The electrode elements may be separated both radially and angularly or in any other convenient manner.

However a larger surface for the detector elements 405 leads to a larger parasitic capacitance, so a lower bandwidth. For this reason it may be desirable to limit the outer diameter of the detector elements 405. Especially in case a larger detector element 405 gives only a slightly larger detection efficiency, but a significantly larger capacitance. A circular (annular) detector element 405 may provide a good compromise between collection efficiency and parasitic capacitance.

A larger outer diameter of the detector element 405 may also lead to a larger crosstalk (sensitivity to the signal of a neighboring hole). This can also be a reason to make the outer diameter of the detector element 405 smaller. Especially in case a larger detector element 405 gives only a slightly larger detection efficiency, but a significantly larger crosstalk.

The electron current collected by detector element 405 is amplified, for example by an amplifier such as a TIA.

In an embodiment, the objective lens array 241 is an exchangeable module, either on its own or in combination with other elements such as the control lens array 250 and/or the detector 240 and/or the beam shaping aperture array 262 and/or the sub-beam forming array 252. The exchangeable module may be field replaceable, i.e. the module can be swapped for a new module by a field engineer. In an embodiment, multiple exchangeable modules are contained within the tool and can be swapped between operable and non-operable positions without opening the electron-optical apparatus 40.

In an embodiment the exchangeable module comprises an electron-optical component, and specifically may be the electron-optical device, which is on a stage permitting actuation for positioning of the component. In an embodiment the exchangeable module comprises a stage. In an arrangement the stage and the exchangeable module may be an integral part of the tool 40. In an arrangement the exchangeable module is limited to the stage and the device, such as the electron-optical device, it supports. In an arrangement the stage is removable. In an alternative design the exchangeable module comprising the stage is removable. The part of the electron-optical apparatus 40 for the exchangeable module is isolatable, that is the part of the electron-optical apparatus 40 is defined by a valve up-beam and a valve down-beam of the exchangeable module. The valves can be operated to isolate the environment between the valves from the vacuum up-beam and down-beam of the valves respectively enabling the exchangeable module to be removed from the electron-optical apparatus 40 whilst maintaining the vacuum up-beam and down-beam of the part of the electron-optical apparatus 40 associated with the exchangeable module. In an embodiment the exchangeable module comprises a stage. The stage is configured to support a device, such as the electron-optical device, relative to the beam path. In an embodiment the module comprises one or more actuators. The actuators are associated with the stage. The actuators are configured to move the device relative to the beam path. Such actuation may be used to align the device and the beam path with respect to each other.

In an embodiment, the exchangeable module is a microelectromechanical systems (MEMS) module. MEMS are miniaturized mechanical and electromechanical elements that are made using microfabrication techniques. In an embodiment, the exchangeable module is configured to be replaceable within the electron-optical apparatus 40. In an embodiment, the exchangeable module is configured to be field replaceable. Field replaceable is intended to mean that the module may be removed and replaced with the same or different module while maintaining the vacuum in which the electron-optical tool 40 is located. Only a section of the electron-optical apparatus 40 is vented corresponding to the module is vented for the module to be removed and returned or replaced.

The control lens array 250 may be in the same module as an objective lens array 241, i.e. forming an objective lens array assembly or objective lens arrangement, or it may be in a separate module

In some embodiments, one or more aberration correctors are provided that reduce one or more aberrations in the sub-beams. The one or more aberration correctors may be provided in any of the embodiments, e.g. as part of the electron-optical device, and/or as part of an optical lens array assembly, and/or as part of an assessment system. In an embodiment, each of at least a subset of the aberration correctors is positioned in, or directly adjacent to, a respective one of the intermediate foci (e.g. in or adjacent to the intermediate image plane). The sub-beams have a smallest cross-sectional area in or near a focal plane such as the intermediate plane. This provides more space for aberration correctors than is available elsewhere, i.e. up-beam or down-beam of the intermediate plane (or than would be available in alternative arrangements that do not have an intermediate image plane).

In an embodiment, aberration correctors positioned in, or directly adjacent to, the intermediate foci (or intermediate image plane) comprise deflectors to correct for the source 201 appearing to be at different positions for different beams. Correctors can be used to correct macroscopic aberrations resulting from the source that prevent a good alignment between each sub-beam and a corresponding objective lens.

The aberration correctors may correct aberrations that prevent a proper column alignment. Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses are vertically close or coincident with the beam apertures. A challenge with positioning correctors at or near the condenser lenses, however, is that the sub-beams each have relatively large sectional areas and relatively small pitch at this location, relative to locations further downstream (or down-beam). The aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference.

In some embodiments, each of at least a subset of the aberration correctors is integrated with, or directly adjacent to, the objective lens array 241. In an embodiment, these aberration correctors reduce one or more of the following: field curvature; focus error; and astigmatism. Additionally or alternatively, one or more scanning deflectors (not shown) may be integrated with, or directly adjacent to, the objective lens array 241 for scanning the assessment sub-beams 211, 212, 213 over the sample 208. In an embodiment, the scanning deflectors described in US 2010/0276606, which document is hereby incorporated by reference in its entirety, may be used.

The detector may be provided with multiple portions and more specifically, multiple detecting portions. The detector comprising multiple portions may be associated with one of the assessment sub-beams 211, 212, 213. Thus, the multiple portions of one detector 240 may be configured to detect signal particles emitted from the sample 208 in relation to one of the primary beams (which may otherwise be referred to as assessment sub-beams 211, 212, 213). In other words, the detector comprising multiple portions may be associated with one of the apertures in at least one of the electrodes of the objective lens assembly. More specifically, the detector 405 comprising multiple portions may be arranged around a single aperture 406 as shown in **FIG 10****,** which provides an example of such a detector.

As shown in **FIG. 10****,** the detector element 405, in which an aperture 406 is defined and configured for the through passage of an electron beam, comprises an inner detecting portion 405A and an outer detecting portion 405B. The inner detecting portion 405A surrounds the aperture 406 of the detector. The outer detecting portion 405B is radially outwards of the inner detecting portion 405A. The shape of the detector may be generally circular. Thus, the inner detecting portion and the outer detecting portion may be concentric rings.

The invention can be applied to various different tool architectures. For example, the electron-optical apparatus 40 may comprise a plurality of electron-optical columns of multi-beams. The electron-optical columns may comprise the electron-optical device 41 described in any of the above embodiments or aspects. As a plurality of electron-optical columns (or a multi-column tool), the devices may be arranged in an array which may number two to one hundred electron-optical columns or more. The electron-optical apparatus 40 may take the form of an embodiment as described with respect to and depicted in **FIG. 4** or as described with respect to and depicted in **FIG. 5****.** An electron-optical column may optionally comprise a source.

As mentioned above, to increase contrast for electron beam inspection the surface of the sample 208 can be illuminated with light prior to the inspection of the sample 208. This process may be called advanced charge control. Such illumination may excite electrons within the sample 208. Such excited electrons within a sample 208 are more likely to interact with impinging electrons from incidental primary sub-beams of the multi-beam. Consequently, such illumination may be used to improve the strength of the signal particle signal. The optical illumination may improve contrast of the detected signal.

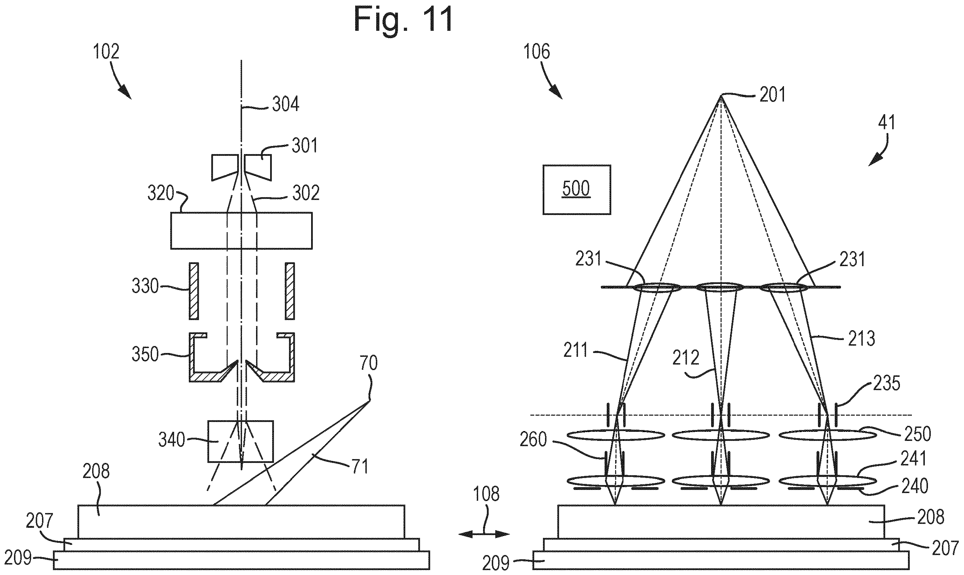

**FIG. 11** depicts an electron-optical apparatus for assessing a sample 208 using charged particles (e.g., electrons). The apparatus comprises a preparatory electron-optical device 102, an assessment electron-optical device 106 and a control system 500. The assessment electron-optical device 106 may comprise the electron-optical device 41 described elsewhere in this document, for example as described with reference to **FIGs. 2-6****.** The control system 500 controls the apparatus to perform various functions as described below. The control system 500 may comprise or consist of a controller 50 taking any of the forms described above with reference to **FIG. 1****.** The control system 500 may comprise a single unit configured to perform all of the control functionality or may comprise a distributed system of units that together allow the required functionalities to be achieved. The control system 500 may be at least partially computer implemented. Any suitable combination of elements (e.g., CPUs, RAM, data storage, data connections, sensors, etc.) may be provided and suitably programmed to achieve some or even all the specified functionality. Any reference herein to an apparatus, device or system being configured to perform functionality is intended to encompass the case where the control system 500 is configured to cause the functionality to be performed (e.g., by being suitably programmed to provide control signals that cause the functionality to happen).

In an embodiment, the exposing of the target area comprises a flood exposure. The preparatory electron-optical device 102 may comprise a flood column configured to provide the flood exposure. **FIG. 11** depicts an example configuration for a flood column in a preparatory electron-optical device 102, although other electron-optical designs of flood column may be used. In this example, the flood column comprises a charged particle source 301, a condenser lens 320, a blanker electrode 330, an objective lens 340 and an aperture body 350. The flood column may also comprise additional components for manipulation of the preparatory charged particle beam 302 such as a scanning element (not shown) and a field lens (not shown). The components of the flood column may be arranged substantially along an axis 304.

The charged particle source 301 may be an electron source. The charged particle source 301 may comprise a charged particle emitting electrode (e.g. a cathode) and an accelerating electrode (e.g. an anode). The charged particles are extracted or accelerated from the charged particle emitting electrode by the accelerating electrode to form a preparatory charged particle beam 302. The preparatory charged particle beam 302 may propagate along a preparatory beam path 302. The preparatory beam path 302 may comprise the axis 304, for example in situations in which the preparatory charged particle beam 302 is not deflected away from the axis 304.

The condenser lens 320 is positioned down-beam of the charged particle source 301, i.e. the condenser lens 320 is positioned in a down-beam direction relative to the charged particle source 301. The condenser lens 320 may focus or defocus the preparatory charged particle beam 302. As shown in **FIG. 11****,** the condenser lens 320 may be used to collimate the preparatory charged particle beam 302. However, the condenser lens 320 may also be used to control the preparatory charged particle beam 302 to create a divergent beam or a convergent beam.

The aperture body 350 may be positioned down-beam of the condenser lens 320. The aperture body 350 may pass a portion, or only a portion and not all, of a charged particle beam propagating along an axis 304. The aperture body 350 may limit the lateral extent of the preparatory charged particle beam 302, as depicted in **FIG. 11****.** The aperture body 350 may also be used to selectively blank the preparatory charged particle beam 302, so as to prevent passage of any portion of the preparatory charged particle beam 302. The aperture body 350 may define an opening. If the lateral extent (or diameter) of the preparatory charged particle beam 302 is larger than the lateral extent (or diameter) of the opening, then only a portion of the preparatory charged particle beam 302 will pass through the opening. The aperture body 350 may thus limit the lateral extent of the preparatory charged particle beam 302, so as to act as a beam-limiting aperture.

The blanking electrode 330 may be positioned down-beam of the condenser lens 320 and up-beam of the aperture body 350. The blanking electrode 330 may selectively deflect the preparatory charged particle beam 302, for example deflect the preparatory charged particle beam 302 away from the axis 304. The blanking electrode 330 may deflect the preparatory charged particle beam 302 away from the opening in the aperture body 350, for example onto a portion of the aperture body 350 that does not comprise the opening, so as to prevent any portion of the preparatory charged particle beam 302 from passing through the opening defined by the aperture body 350. The blanking electrode 330 may blank the beam so that beam does not pass through the opening of the aperture body 350. However, the combination of the blanking electrode 330 and the aperture body 350 may also be used to selectively blank the preparatory charged particle beam 302, i.e. to selectively prevent passage of at least part the preparatory charged particle beam 302 through the opening in the aperture body 350. That is, the combination of the blanking electrode 330 and the aperture body 350 may selectively control the proportion of the preparatory charged particle beam 302 that passes the opening.

The objective lens 340 is positioned down-beam of the aperture body 350. The objective lens 340 may focus or defocus the preparatory charged particle beam 302. As shown in **FIG. 11****,** the objective lens 320 may be used to control the preparatory charged particle beam 302 so as to create a divergent beam, thereby increasing the spot size on the sample 208 and increasing the area of the surface on the sample 208 that is flooded with charged particles. A more divergent beam may generate a beam spot on the sample with a larger field of view. However, in some situations, the objective lens 340 may be used to control the preparatory charged particle 302 so as to create a convergent beam, thereby focusing the preparatory charged particle beam 302 onto the sample 208. A more convergent beam may generate a beam spot on the sample with a smaller field of view.

In an embodiment, the assessment electron-optical device 106 exposes the sample 208 with a multi-beam of charged particles, the multi-beam comprising a plurality of individual beams of charged particles. The example of **FIG. 11** shows a multi-beam comprising three individual beams but in practice the multi-beam may comprise many tens, hundreds or thousands of beams.

In an embodiment, the assessment electron-optical device 106 comprises a electron-optical device 41. The electron-optical device 41 may take any of the forms described above with reference to **FIG. 3** and **7** for example, such as with an array of electron-optical elements proximate the sample 208, such as an objective lens array 241 or detector array 240. In an embodiment the assessment electron-optical device 106 comprises an objective lens comprises a plurality of objective lenses for different beams of the assessment charged particle beam. In the particular example of **FIG. 11** the assessment electron-optical device 106 corresponds to the arrangement of **FIG. 3** and may operate and/or take any of the forms described above with reference to **FIG. 3****.** The electron-optical device 41 is used during the assessing of the sample 208 to direct the charged particles onto the sample 208 and to detect the signal charged particles from the sample 208.

In an embodiment electron-optical apparatus is for assessing a sample at an assessment location. In **FIG. 11****,** the assessment location is below the assessment electron-optical device 106. As shown in **FIG. 11****,** in an embodiment the electron-optical apparatus comprises an assessment charged particle-optical device 106, a preparatory charged particle-optical device 102 and a photo-stimulation module 70 which in an arrangement may take the form of a light source, for example as depicted in **FIG. 11****.** The assessment charged particle-optical device 106 is configured to project an assessment charged particle beam 211-213 along an assessment beam path toward an assessment location. The assessment charged particle beam is for assessing a sample 208 at the assessment location. The preparatory charged particle-optical device 106 is configured to project a preparatory charged particle beam along a preparatory beam path. The preparatory charged particle beam is for preparing a sample for assessment.

The photo-stimulation module 70 is configured to generate light for photo-stimulation of the illuminated surface. The photo-stimulation module 70 may be comprised in an advanced charge control module, e.g. an ACC module. The photo-stimulation module 70 may be part of a projection system (i.e an optical projection system) for illuminating the sample before assessment of at least a sample portion of the sample. For example the light source as depicted in **FIG. 11** may illuminate a beam of light directly towards the sample.

When an electron beam scans the sample 208, charges may be accumulated on the sample 208 due to the large beam current, which may affect the quality of the image. The photo-stimulation module 70 may direct light 71 on to the sample 208, so as to control the accumulated charges due to effects such as photoconductivity, photoelectric, or thermal effects.

In an embodiment the photo-stimulation module 70 comprises a light source such as a laser light source. Laser light is coherent. However, other types of light source can alternatively be used. In an embodiment the laser light source is configured to emit light, generally in a light path 71, having a wavelength in the range of from 400 nm to 850 nm, preferably from 450 nm to 800 nm. The selected wavelength may correspond to a wavelength absorbed by the material of the sample 208 on which the light is incident. The selected wavelength may tend to excite electrons in the sample 208 on incidence of the light with the sample 208.

By illuminating the sample 208 with the light 71 the defect contrast is significantly improved. This technique, which may be referred to as voltage contrast, may be used to measure whether there is a proper electrical connection between a contact and the substrate of the sample 208. Depending on the secondary electron yield (<1 or >1) the contact to the N+ or P+ doped region on the substrate forms a diode in reverse. As a result, it can be the case that it is not possible to distinguish between a proper and a bad electrical connection for either the N+ or the P+ contacts. By illuminating the sample 208 with light 71 (ACC) the diode in reverse is made conductive. As a result, the contact will not charge in case there is a proper electrical connection between contact and substrate, but it will charge in case the electrical connection is bad.

The assessment electron-optical device 106 may have a field of view. During assessment of a sample, the field of view may be the area on the surface of the sample 208 on which electrons projected by the assessment electron-optical device 106 may be incident. The field of view may be up to 1 mm, for example 5 mm, for example 10 mm or even 20 mm. The assessment electron-optical device 106 may have a large field of view. Since one or more of the elements, for example plates which may form electrodes of lens arrays, of the electron-optical device may be comprised in a respective substrate of for example silicon, the plate forming the most down-beam surface of the device may be larger than the beam grid in surface area. A working distance between the assessment electron-optical device 106, for example the facing surface of the assessment electron-optical device 106, and the sample 208 may be restricted (e.g. have a maximum value for example in the range of 10 to 100 micron as described previously), for example for electron-optical reasons as disclosed herein in relation to **FIGs. 2 to 5****.** These dimensions may create a gap that is limited or small (e.g. narrow) in height (or along the direction of the beam path) and wide (for example in a direction across or even orthogonal to the beam path). The gap may be considered to be narrow and wide. The gap may have a restricted or limited aspect ratio, i.e. of height (e.g. along the direction of the charged particle beam path) relative to width (for example of the field of view of the beam grid). The dimensions of the gap make it difficult to illuminate the sample photonically for photo-stimulation of the sample (or use ACC).

An embodiment of the invention is expected to achieve photonic stimulation (e.g. ACC with an electron-optical architecture of an assessment electron-optical device 106 in which the bottom (or facing surface) of the device has a small displacement (i.e. the small gap) from the sample 208 and may have a large field of view.

In an embodiment the contacts with a bad electrical connection to the substrate prior to the assessment are charged by means of the preparatory electron-optical device 102. In order to make sure both the N+ and P+ contacts with proper electrical connection do not charge, the sample 208 may be illuminated by the light source 70 prior to the assessment. This can be done during the projection of the preparatory beam (e.g. flooding), or after the projection of the preparatory beam. Because the light beam illumination is done prior to the assessment a small gap between the assessment electron-optical device 106 and the sample 208 is less of a problem. The light source 70 may be part of the preparatory electron-optical device 102, and not part of the assessment electron-optical device 106.

By controlling the landing energy of the electrons of the preparatory electron beam, the contacts with bad electrical connection can be charged positively or negatively. During the assessment the contacts with bad electrical connection will charge further; in addition the contacts with a proper electrical connection but connected to a diode in reverse will charge further. In an embodiment the charging during projection of the preparatory electron beam and during projection of the assessment electron beam are in the same direction, for example by projecting the preparatory electron beam with the same landing energy as the landing energy of the assessment electron beam.

During projection of the preparatory electron beam (e.g. during flooding), defective contacts are charged, "diode in reverse" contacts are charged and "diode in conduction" contacts remain discharged. During projection of the light 71, defective contacts remain charged, "diode in reverse" contacts are discharged and "diode in conduction" contacts remain discharged. During projection of the assessment electron beam defective contacts are charged further, "diode in reverse" contacts are charged and "diode in conduction" contacts remain discharged. It may be possible to distinguish between the defective contacts that are charged further and the "diode in reverse" contacts that are merely charged. By performing the projection of the preparatory electron beam and the projection of the light beam, it is easier to distinguish between good contacts and bad contacts. It may not be necessary to project the light beam simultaneously with projection of the assessment electron beam.

If for a specific voltage contrast application use of photonic stimulation, e.g. ACC, is mandatory, an embodiment of the invention is expected to increase throughput, for example by allowing use of photonic stimulation (e.g. ACC) in the context of an apparatus with a large field of view and a small gap to the sample 208.

In an embodiment of the invention, the preparatory electron-optical device 102 projects a preparatory beam onto the sample 208 before assessment to charge the contacts in the sample 208 that have a bad electrical connection to the sample 208 (which may be referred to as bad contacts). During or shortly after flooding, such as between a preparatory location where the preparatory electron-optical device 102 projects a preparatory beam onto (e.g. floods) the sample 208 and an assessment location where the assessment electron-optical device 106 is used to assess a sample 208, the sample 208 may be illuminated with light 71 suitable for ACC. This may help to ensure that contacts with sound electrical connection (which may be referred to as good contacts) do not charge.

In an embodiment the preparatory charged particle-optical device 102 is configured to project the preparatory charged particle beam 302 while the photo-stimulation module 70 projects the light 71 toward the illumination location. The projection of the preparatory electron beam and the projection of the light 71 may be performed in parallel. Alternatively one may be done after the other or their time periods may partially overlap each other.

In an embodiment the photo-stimulation module 70 is associated with the preparatory charged particle-optical device 102. In an embodiment the photo-stimulation module 70 is integrated with the preparatory charged particle-optical device 102. Alternatively (or even additionally), in an embodiment the photo-stimulation module is associated with the assessment charged particle-optical device. In an embodiment the photo-stimulation module 70 is integrated with the assessment charged particle-optical device. Photo-simulation using a photo-stimulation module as described below can be an alternative to flood exposure using a preparatory charged particle-optical device. Photo-stimulation may occur at the assessment position for example using a charged particle device comprising the photo-stimulation module. In an embodiment a photo-stimulation module can be provided in an assessment charged particle-optical device lacking a preparatory charged particle-optical device, desirably requiring just the assessment charged particle device; for example such an assessment apparatus would comprise the photo-stimulation module 70 without the preparatory charged particle optical device. In other cases, photo-simulation using a photo-stimulation module 70 as described below can be performed in addition to flood exposure using a preparatory charged particle-optical device. Photo-stimulation at the assessment position may be desirable for some use cases requiring assessment at or soon after photo-stimulation.

In an embodiment photo-stimulation is performed using stimulation light 71 having a wavelength in the range of from 400 nm to 850 nm, preferably from 450 nm to 800 nm. The selected wavelength may correspond to a wavelength absorbed by the material of the sample 208. The selected wavelength may tend to excite electrons in the sample 208 on incidence of the light, for example in a light path, with the sample 208. The selected wavelength is desirably selected such that photons of the stimulation light have energy, at least as great as, desirably greater than a band-gap of the sample. Light of the selected wavelength for simulating a portion of the sample, may be referred to as stimulation light. Stimulation light can be provided throughout a process of assessment, it is not necessary to modulate the intensity of the stimulation light or synchronize it with energization of the charged particle beams. The power requirement for photo-stimulation is not particularly high, such that power consumption issues or undesirable heating are unlikely to arise. In case the stimulation light cannot be precisely directed to the desired location it is possible to broaden the beam and increase the power. The power density of the light beam may have an order of magnitude in the range of 10 to 1000 mW/mm². For a beam grid with a field of view of 20 mm at a sample surface, the power applied may be of an order of magnitude in the range of 50 to 5000 mW.

An embodiment of the invention provides planar optics for advanced charge control in a charged particle device for example as shown in and described with reference to for example **FIGs. 3 to 5** **and** **11.** Such a charged particle device may be comprised in a charged particle system such as an assessment system. One or more electrostatic elements of the charged particle device may be referred to as a MEMS element. The charged particle system may be referred to as a multi-beam system, configured to project a plurality of charged particle beams towards a sample for assessment, such as inspection of at least part of the surface of the sample. Such a charged particle system be referred to as a multibeam inspection system (or MBI system). The invention may be embodied in a photo-stimulation module 70 as will be described. A photo-stimulation module 70 may replace or be addition to the photo-stimulation module 70 as the arrangement shown in and described with reference to **FIG 11****.**

For Voltage Contrast the use of Advanced Charge Control (ACC) is highly desired. By illuminating the sample with a light beam 71, for example using a photo-stimulation module, while performing assessment of the sample for example (i.e. the e-beam defect inspection) the defect contrast is significantly improved. Ease of identification of defects improves using Advanced Charged Control techniques. Charged particle systems in which ACC have been implemented have a macroscopic objective lens as part of the optical system such as a photo-stimulation module. Such a lens has enough working distance to direct a light beam 71 onto the sample, in the gap between the sample 208 and the facing surface of the charged particle device 41. Typically the working distance is at least a few millimeters, for example 1 to 10 mm, such as 5mm or more. Also the field of view of such optical systems is limited to < 10 or 50 micron.

In charged particle system comprising an objective lens array (such as shown in and described with reference to **FIGs. 3 to 5** **and** **11,** which may be referred to as a MEMS based system) the working distance may be less than 500 micron, such as less than 100 micron, for example in the range of 10 to 70 micron, such as only 50 micron. The field of view can be as large as 3 mm, 5 mm, 10 mm or as much as 20 mm. Light directed into such a gap would have difficulty reaching a portion of the sample on which the beam grid is incident, and by which it is absorbed, i.e. the light is intended to be absorbed. The angle of illumination of light into the gap may exceed the angular threshold, for example with respect to the normal of the sample surface, at or below which the illuminating light may be absorbed by the material, i.e. of the sample, so at such an angle that exceeds the angular threshold most if not all the light is reflected. Alternatively expressed the threshold may correspond to a small angle with respect to the sample surface below which most if not all of the light is reflected (i.e. not absorbed). The known method clearly cannot be used in such charged particle system with an objective lens array.

Transporting light on to the inspected sample with a stack of planar elements comprising electron-optical arrays is not a straightforward task due to the working distance being so small. There have been multiple proposals on directing laser light through this gap and harnessing total internal reflection for illuminating a portion of a sample surface with stimulation light. Such a portion of the sample surface may have a surface area larger than the aperture array in the facing surface of the stack. (The field of view or cross-section of such a light path at the sample surface may have a dimension corresponding to the field of view of the beam grid through the aperture array, or the dimension across the aperture array, for example 20 mm.) Those solutions, though functional, suffer from power loss due to reflectivity, impart heat load on the detectors, and make certain assumptions about the inspected sample (e.g. reflectivity, flat surface). In particular a sample might have grating-like topology completely changing the assumed reflection angles. In another solution, stimulation light is illuminated through the beam apertures. However, the beam apertures required for the desired electron-optical performance of the charged particle system are so small that the stimulation light diffracts, also leading to undesirable light loss. Such diffracted light may cause unwanted heating elsewhere in the charged particle device 41 at unwanted locations.

It is proposed to add a layer to transport light, such as stimulation light, either through total internal reflection inside a layer, in integrated waveguides in the stack, or in integrated waveguides in a completely separate integrated optics (IO, also called integrated photonics) layer. The layer for transporting light (or a light transport layer) provides photonic illumination that is compatible with the stack. The layer maybe referred to as a planar optical member.

Three embodiments of such an arrangement are described below and illustrated schematically in **FIGs. 12 to 14****.** It should be noted that the features may be used as alternatives, or may be combinable as may be desired. A stack may comprise more than one light transport layer of different embodiments.

In an embodiment, a light guide plate 501 at the bottom element (or sample facing element) for example as a layer of the element of the stack 502 is shown in **FIG. 12****.** The layer may be planar and may take the form of a slab, for example an embodiment of a planar optical member. The layer may be referred to as a slab waveguide. An additional layer (either as part of an element having another function or as a separate element) that is transparent in visible wavelengths, guides the stimulation light and couples it to free space towards the sample using out-coupling features such as apertures (such as holes) or recesses (such as dimples 503) in a surface of the additional layer.

As the additional layer is part of the stack, a plurality of apertures may be defined in the layer for passage of the charged particle beams of the beam grid and optionally signal particles from the sample 208. The position of the apertures 504 in the layer may be the same as the element of which the additional layer forms part and/or the other elements of the stack. Thus the slab waveguide may be described to have through-holes 504 (or apertures) for passage of the charged particle beams to and/or from the sample.

The thickness of the additional layer is generally many wavelengths, and total internal reflection is relied upon for guiding the light. However, a thickness close to the wavelength can also be envisioned, as it will still guide the light, though not any more through total internal reflection but by the single-mode, or few-mode, slab-mode guiding due to a refractive index contrast with the surrounding. The out-coupling features of the such as the holes and/or dimples may break this total internal reflection and/or guide light locally. The light may be reflected, diffracted and/or scattered to outside of the slab waveguide, towards the sample under inspection for example a surface topography with a region e.g. for reflecting light towards a sample; such a region may have a saw-toothed topography (or shape). Other types of out-coupling feature include micro-mirrors (which may include a parabolic micromirror), and microlenses, which can be formed by focused ion-beam milling or three-dimensional-printing. Such surface topography for example with regions for example for reflecting light are disclosed in WO 2022228943 which is hereby incorporated by reference so far as the disclosure of such a surface topography.

Out-coupling features can be configured to direct stimulation light 71 to be coincident (i.e. incident at the same place and/or time) on the sample with the charged particle beams.

Desirably, for stimulation of the sample material, the stimulation light is coincidently incident on a portion of the sample surface with an incidental charged particle, that is at the same time. In some cases, illumination shortly before the incidence of the charged particle beam can be effective. The stimulation light is desirably incident at the same location as the respective charged particle beam. The incident illumination (e.g. of stimulation light) desirably extends over a portion of the sample surface over which the charged particle beam is scanned. Illumination of the portion of the sample surface may start before the charged particle beam is scanned over the portion. The illumination may continue after the portion is scanned by the charged particle beam (although it may be desirable to stop illumination as soon as the portion has been scanned by the charged particle beam). Desirably the charged particle beam is scanned over the portion of the sample surface during photonic illumination of the portion.

The field of view of a charged particle beam less than 50 nm, for example less than 20 nm such as smaller than 10 nm; however the charged particle beam is continually scanned relative to the sample surface. For example the charged particle beam may be scanned for example electrostatically, for example using a scan deflector, across a range of less than 10 micron, for example less than 5 micron for example less than 1 micron in a scan direction. The sample may be continually scanned in a different direction from the scan direction electrostatically and/or by mechanically scanning the stage and thus the sample. Such mechanical scanning may be by continuously scanning the sample relative to the path of the beam grid (i.e. the charged particle device 41) or scanning the sample relative to the path of the beam grid between sequential steps of the sample relative to the path, for example in a direction different to the scanning direction of the stage.

The point of incidence, such as a light spot, of a light beam therefore desirably has a larger dimension, for example diameter, than the range of the electrostatic scan of the beam, for example larger than 1 micron, even as large as 5 or even 10 micron. The light beam at the sample (e.g. light spot and/or the portion of the sample surface on which the stimulation light, for example as a light beam) should have a cross-sectional area larger than the area scanned by the electron beam. This ensures stimulation of the material of the sample over which the charged particle beam is scanned.

Having the cross-sectional area of the light spot much larger than the cross-sectional area of the charged particle beam is not a hindrance; however it is undesirably inefficient. Excess sample surface exposed to the stimulation light is a heat load. In an embodiment, there is a light spot for each charged particle beam of the beam grid. A limited surface area of the sample is thus illuminated with the stimulation light compared to known systems. Such a known system is disclosed in European Patent Application 21171331.8 filed on 29 April 2021 which describes illuminating the entire portion of sample surface in which the charged particle beams of a beam grid are incident, which can have cross-section with a dimension of several millimeters, for example from 1 to 20 mm in different directions. (The entire portion of the sample surface may face the facing surface of the electron-optical device in which the array of apertures are defined for the passage of the charged particle beams of the beam grid). For a light spot according to the present invention of 5 micron and a beam pitch of the beam grid of 50 micron, the heat load can be reduced by as much as two orders of magnitude (by a factor of one hundred) relative to illuminating the entire portion of the sample surface on which charged particle beams of the beam grid are incident. Therefore, although the field of view of the individual light spots is limited, the effective field view of all the light spots of stimulation light is at least as large as the field of view of the beam grid at the sample, desirably larger.

Although it is desirable that the sample surface is illuminated with stimulation light during the scanning of a respective charged particle beam over the sample surface, this is not necessarily the case. As disclosed in European Patent Application 22201416.9 filed on 13 October 2022, the stimulation light may illuminate a portion of the sample surface before the incidence of the respective charged particle beam. Desirably the time period between cessation of illumination with the stimulation light and incidence of the charged particle beam is brief, i.e. as short as possible. Such a time period may be milliseconds to micro-seconds which may depend on the use case, the material inspected and the defectivity of the material in the region of the portion inspected.

Another embodiment, which may have the same features of the previous embodiment unless otherwise stated, is shown in **FIG. 13****.** In this embodiment light, for example stimulation light, is out-coupled at the bottom of the stack 502 desirably from a planar optical member. An element in the stack, for example configured to face a sample e.g. as the bottom of the stack, may comprise a planar optical member such as an optical waveguide, such as an integrated photonic waveguide, to guide the light. Such an element may be a detector, e.g., a detector array, or an electrode plate. A layer (e.g. another layer 505) of, for example, the element may provide at least part of the facing surface of the stack. The layer may comprise the optical wave guide, e.g. the integrated photonic waveguide. The layer 505 may leave portions of the element having an electron-optical function, such as detector elements of the detector areas, uncovered, for example exposed. The layer 505 may have volume sufficient to comprise the optical wave guide. The layer 505 may be an integrated optics layer, used for (1) waveguide routing, (2) coupling out the light from the waveguides to free space for illuminating the sample under inspection.

The integrated optics layer may comprise waveguide routing for routing the waveguides for example, e.g. along a routing path, through the grid of detector elements, for example between the detector elements. The integrated optics may comprise out-couplers, for example grating couplers, to couple out the light from the routing of the waveguides. The integrated optics layer may comprise an optical system (which may also be referred to as an optical circuit) for example comprising the waveguide routing and/or an out-coupler. The integrated optics layer has a high refractive index layer. The high refractive index layer that has a top and bottom cladding with a lower refractive index, to allow for light confinement and guiding within the waveguides.

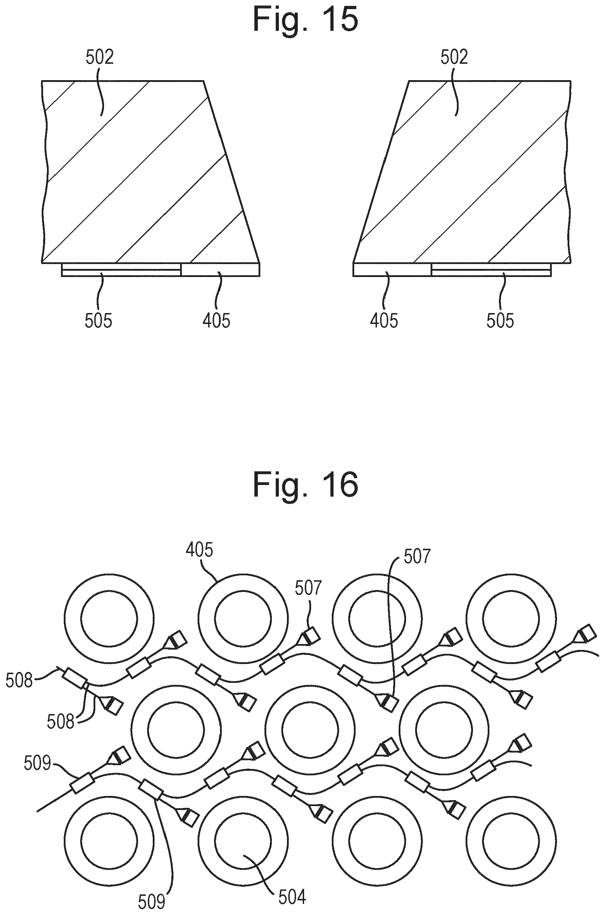

**FIG. 15** is an enlarged cross-sectional view of the embodiment of **FIG. 13****.** The enlarged cross-sectional view shows the element which in this case is a detector in which is defined an aperture (not numbered). On a surface adjacent the aperture defined in the bottom surface of the substrate as depicted is a detector element 405. Further outward from the aperture on the bottom surface is the layer 505, e.g. as the integrated optics layer. **FIG. 16** is a schematic view of the bottom surface of the detector showing detector elements 405 and the integrated optical circuit. The integrated optical circuit may be a type of optical system with waveguides 508, power splitters 509 and grating couplers 507 (or more generally out-couplers).

The integrated optics (IO) layer has in-couplers (not shown), waveguides 508, power splitters 509 and out-couplers 507. The in-couplers couple the light into the waveguides, e.g. from fibers. The in-couplers may be grating couplers. The waveguides 508 transmit the light. The power splitters 509 guide the light to multiple out-couplers 507 such as grating couplers. The out-couplers 507 couple light out from the waveguides 508 to free space and onto the sample 208 being inspected. Grating couplers (as in-couplers or out-couplers) can support multiple wavelengths.

Coupling light from fibers into waveguides can be done in various different ways, for example: edge coupling, grating coupling, and micromirrors. In edge coupling the fiber is brought in-line with the waveguide at close proximity. In a grating coupler the light is coupled from the fiber into the waveguide. A micro-mirror redirects the light from the fiber and focuses it into the waveguide.

Various arrangements for splitting of integrated optical waveguides are known, for example: Y-splitters; multi-mode interferometers (MMI); and directional couplers.

As an alternative to grating couplers, mirrors can be fabricated at the end of the waveguide with focused ion beam (FIB) cuts, or 3D printed into etched holes, and used to direct light onto the sample surface. Fabricating such mirrors requires a more significant effort, but enables a more straightforward choice of illumination wavelengths, or a freer (less restricted) choice of wavelength of the stimulation light. Mirrors are inherently broadband and insensitive to wavelength; whereas grating couplers are dispersive, so sensitive to wavelength.

The integrated optics layer (or more generally the planar optical member) can be created on a sacrificial wafer. The integrated optic layer may be secured to the stack of electron-optical elements. As such electron-optical element may be made used MEMS processing techniques, the stack may be referred to as a MEMS stack. The stack (e.g. MEMS stack) may be an embodiment of stack herein disclosed. The stack may exist so that the integrated optics layer may be secured by adhesively bonding to the existing stack. The integrated optics layer may be secured to an element, such a planar electron-optical element such as an electrode. In an embodiment, the integrated optical layer may be secured to a planar electron-optical element which comprises CMOS such a detector; for example to t the integrated optical layer may be secured to he surface of the planar electron-optical element on which CMOS layers may be provided. In a different embodiment the planar electron-optical element may be secured to side of the electron-optical element without a CMOS layer, or both sides of the electron-optical element The integrated optical layer may be secured (e.g. fixed such as adhered) to detector array comprising CMOS elements such as around the detector elements of the detector array. The side of the electron-optical element providing the detector elements may be adhered to a surface of a CMOS layer. The sacrificial wafer can be removed by known techniques such as etching, cleaving, chemical mechanical polishing (CMP) or wafer thinning. An example of bonding an integrated optics layer, that works at telecom wavelengths (1300-1600 nm), is the InP-membrane-on-Si (IMOS) platform from TU/e, or the WIPE project from the TU/e. (see *https:*//*photonics-benelux.org*/*wp-content*/*uploads*/*pb-files*/*proceedings*/*2018*/*39.pdf* for a brief example on the bonding process). To keep clear (i.e. avoid) detector elements which comprise metals, the integrated optics layer either extends underneath the detector elements, especially metal features of the detector element, or the integrated optics layer is spaced apart from the detector elements. For example, paths of the waveguide routing within the integrated optics layer pass between detector elements as shown in **FIGs. 15 and 16****.** For example the integrated optics layer may be formed in the substrate of the detector. Thus the integrated optics layer keeps clear of the detector metal, desirably, all together. It is noted that the bonding is described with reference to the integrated optics layer, other types of planar optical member may be similar secured to an element of the stack.

The integrated optics layer can be mounted to (or otherwise incorporated into) a support substrate which is positioned within the stack. As described below, the support substrate may have an electron-optical function within the stack.

Materials in which a waveguide can be formed include SiO, SiN, AlO, without limitation thereto. Waveguides can be formed by known processes using only a few lithography steps. Out-couplers such as diffraction gratings may be formed by etching, optionally filling trenches created by etching with material of a different refractive index. Splitters with various different splitting proportions can be used to create a variety of waveguide structures, such as tree-like structures. Waveguides may be formed in a layer that has other functional devices or structural properties.

A further embodiment may have the same features of the previous embodiment unless otherwise stated, is shown in **FIG. 14****.** In this embodiment, stimulation light is out-coupled from the planar optical element (or plate or planar optical member) and then passes through apertures for the charged particle beams in a bottom-most element of the stack 502 shown in **FIG. 14****.** The planar optical element is now a separate layer 506 that is separate from an electron-optical element of the stack; such that the planar optical element is itself an element of the stack 502. Optionally, the planar optical element may be apart from other elements, such as planar elements, of the stack 502.

In an arrangement such as that of **FIG. 14** where the planar optical element, for example a photonic integrated circuit, is not the bottommost element of the stack, additional optical elements may be provided to assist the propagation of the stimulation light through apertures in elements of the stack that are below (i.e. closer to the sample) than the planar optical element. For example, the sides of the apertures may be treated or coated to reduce absorption of the stimulation light. Alternatively or in addition, one or more light guiding structures (which may be a type of waveguide such as hollow-core optical fibers) may be provided in a respective aperture and/or proximate to a respective aperture, desirably without adversely influencing the electric field around the path of a sub-beam through the aperture. The light guiding structures guide the light from the planar optical element, e.g. photonic integrated circuit, towards the portion of the sample surface, e.g. the region of interest on the sample under assessment, e.g. inspection. The light guiding structure may comprise an end facet. The end facet may be in the respective aperture, for example to provide at least part of a surface of the aperture through an element of the stack. An optical element may be provided at the entrance and exit of the aperture and/or the end facet of the light guiding structure in the down-beam elements of the stack to guide stimulation light into and out of the apertures for example towards the sample. It is desirable that any optical elements provided in apertures of the stack not hinder or alter the passage of electron beams through such apertures.

To avoid interference with the electron beams as they are projected to a sample, such optical features that are not part of the bottom most element of the stack may be located in a field-free area (i.e. free of an electric field). Such a field-free area may be present in any of the arrangements shown in **FIGs. 3 to 7****,** up-beam (or above) objective lenses 241, such as between lens arrays 241 and 250 or above control lens arrays 250. In such an arrangement a photonic integrated circuit and the light guiding structure (such as the hollow core optical fiber) would be position up-beam (e.g. above) an electrode stack. Scattering of light from the light guiding element (such as the hollow fibers) on down-beam elements such as plates or elements of the stack may occur. To suppress the scattering, the end facet of such a light guiding element could be shaped to improve the delivery of the light. For example, the end of a fiber may be shaped as a lens to reduce the divergence of the beam within the limited space available. Such a lens feature may be the rim of the end of a hollow fiber.

The optical planar element may be secured to an adjacent element in the stack via a spacer in which is defined an aperture for the path of the charged particle beams of the beam grid. This arrangement is different from the embodiment in which the integrated optical layer (or integrated optics layer) is comprised in another element of the stack such as a detector for example by bonding the integrated optics layer to the bottommost element of the stack (e.g. the detector). This present arrangement proposes the integrated optics layer, for example as a planar optical element, such as an integrated optics element, to be positioned up-beam along the path of charged particle beams of the beam grid (e.g. above the bottom element of the stack 502). Light is coupled out of the integrated optics, through the apertures in the bottom element for the charged particle beams of the beam grid, and onto the sample.

Materials that can be used to form a planar optical member are not limited. Such materials may comprise any materials sufficiently transparent to the stimulation light, e.g. glass, plastics, quartz, SiOx, which may depend on the selected wavelength for the stimulation light. A material having a relatively high refractive index at the wavelength of the stimulation light is desirable for the material. A waveguide may be formed using two media of different refractive indexes, one relatively high and one relatively low at the wavelength of the stimulation light, the low refractive index material surrounding the high refractive index material. The low refractive index medium may be the environment surrounding the waveguide, e.g. air or vacuum. Desirably the materials are low outgassing in vacuum.

It is noted that the stimulation light may be selected depending on the material intended to be stimulated, which is desirably a semiconductor, such as silicon or germanium, which may be doped. The stimulation light may have a wavelength corresponding to photon energy greater than a band-gap of the sample, as discussed above.

Stimulation light can be coupled into a planar optical member (in-coupling) by a variety of types of in-couplers and methods. For example the in-couplers may be diodes mounted on or incorporated into the rim (or edge) of the planar optical member. The in-couplers may be provided by in-coupling features, such as diffraction gratings and/or relief features, on a major surface of the planar optical member. The in-couplers may comprise may be or may cooperate with optical fibers or prisms. The in-couplers may comprise a combination of two or more these different features.

Unless the context otherwise indicates, the term "plate" is used herein to denote a self-supporting structure that may comprise multiple layers. Layers of a plate may be functional, such as electrodes or integrated optics, or structural, or both.

The stack disclosed herein with respect to the invention may comprise at least one element, more typically a plurality of elements, such as plates, which may be planar. The elements may comprise at least one detector, for example a detector array of detector elements; a beam shaping aperture array; one or more electrodes of a lens array; a corrector array which may be active (e.g. comprising a plurality of apertures which may be associated with respective beams or groups of beams of the beam grid); or any other electron-optical element. Such an element may be, or otherwise may be associated with the associated with an objective lens array 241, a deflector array, a beam shaping array 262, a control lens array 250, a sub-beam forming array 252, a scan deflector 260, etc. for example as shown in and described with reference to any figure herein, such as **FIGs. 3 to 5** **and 11.**

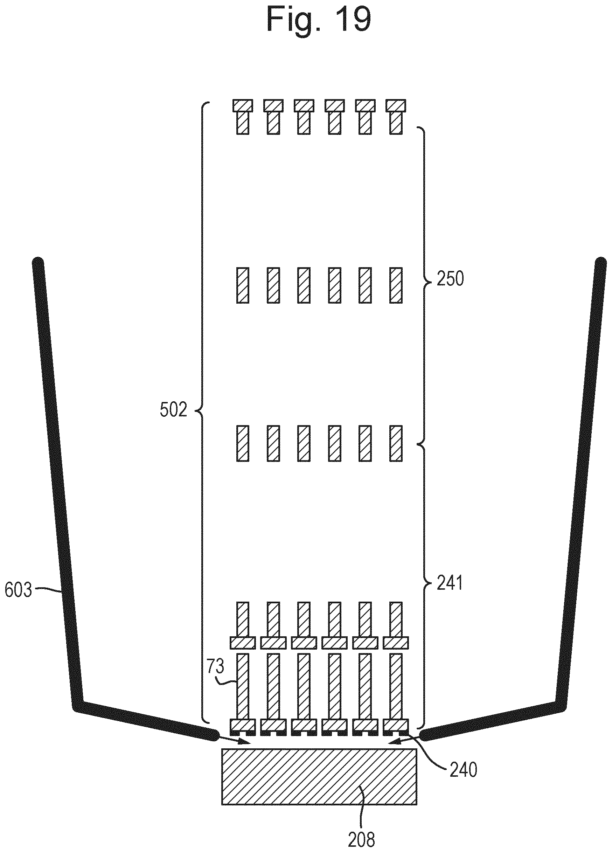

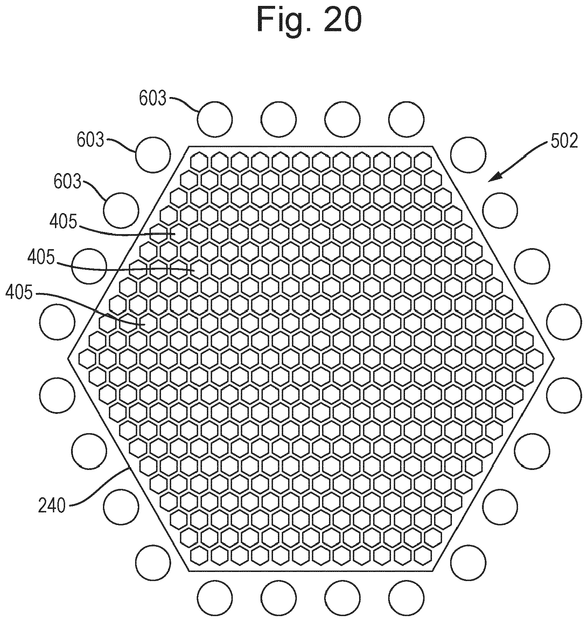

The planar optical member, which according to the different embodiments may be a light guide plate or a layer such as an integrated optics layer 505, may be formed in a layer of any element of the stack, such as the detector, an aperture array or an electrode of a lens array. The element of the stack in which the planar optical member may be formed may function as a support substrate for the planar optical member. Additionally or alternatively, the planar optical member is an element (such as a separate layer 506) separate from other elements of the stack. In an embodiment, the planar optical member is the most up-beam element of the stack, and/or in a field-free region of the stack, e.g. during operation. Such a planar optical member may be located up-beam of the bottom of the stack, such as up-beam of the bottom of the charged particle device, such as up-beam of (e.g. above) an objective lens array. In these arrangements light may be in-coupled to the planar optical member using, for example, one more optical waveguides such as optical fibers or in-coupling waveguides, for example as will be described later herein with respect to an embodiment depicted **FIGs 19** **and** **20****..**

In an arrangement, the in-coupling optical waveguide (or waveguides) may out-couple light directly to the sample surface under inspection. Relative to the disclosure of European Patent Application 21171331.8 filed on 29 April 2021, the in-coupling optical wave guide may have waveguide ends positioned within the vacuum chamber and proximate to the stack of elements, to out-couple light into the gap between the sample and facing surface of the charged particle device 41, i.e. the facing surface of the stack. The in-coupling waveguide may be one waveguide which branches to have multiple ends; or a plurality of waveguides having respectively an end or a plurality of ends. The waveguide ends may be positioned around the perimeter of the stack, for example equidistantly spaced around the perimeter of the stack. In an arrangement the waveguides may pass through the facing element of the stack (i.e. the element configured to face a sample) so that the ends are positioned around and more proximate to the aperture array in the facing surface. The waveguide ends may be shaped and/or angled so that during operation, stimulation light may out-couple from the waveguide ends to illuminate the portion of the sample surface under inspection by a plurality of charged particle beams. These arrangements may illuminate a greater proportion of the sample surface with stimulation light than other embodiments. These arrangement use optical waveguides (e.g. optical fibers) to enable light to be projected from a position closer to a portion of the sample surface under inspection with increased absorption efficiency than do known illumination arrangements.

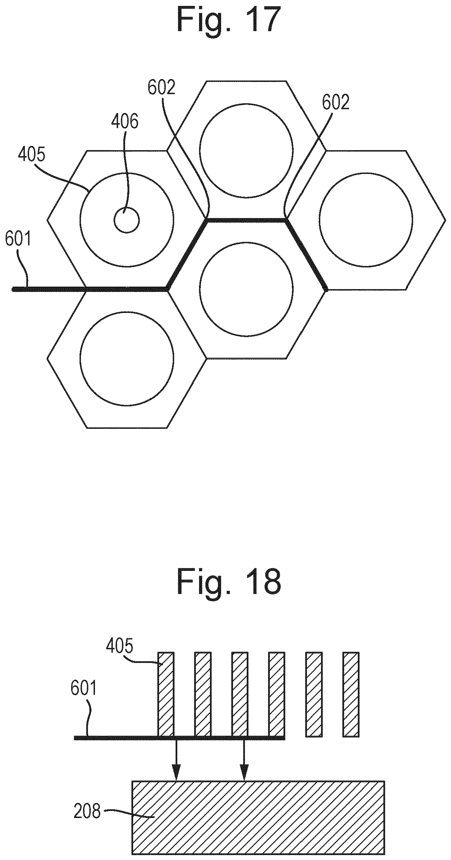

**FIGS. 17** and **18** depict such an arrangement using an optical fiber 601 to distribute light to emission points 602 from a planar element in the stack, for example on the lower face of the stack. Such optical fibers 601 may be considered to be within the stack, such as associated with, on or in a planar element of the stack, such as detector 204 (for example as a plate) comprising detector elements 405. The arrangement shown in **FIG. 18** is an example of the fiber 601 on a surface of detector 240 extending between different detector elements 405; note that such a fiber 601 would not occlude the apertures associated with respective detector elements 405. Fiber 601 follows a meandering or serpentine path between detector elements 405, for example as shown in **FIG 17****,** so as not to prevent any signal electrodes emitted from sample 208 being incident on detector elements 405. Emission points 602 can be created by arranging for sharp bends in the optical fiber 601, or by creating surface irregularities on the optical fiber 601. Mirrors, lenses or other dispersive elements may be provided adjacent exit points 602 in order to distribute the stimulation light as desired. Such dispersive elements may include any suitable dispersive element, such as described with reference to any other embodiment described here, for example as depicted in and described with reference to **FIGs. 12, 13****,** **15** and **16****.** If an arrangement using an optical fiber 601 is applied to an arrangement as shown in **FIG. 14****,** it may be desirable to provide optical elements at the exit points 602 to direct light into the apertures in the lower elements of the stack 502.

Light from a stimulation light source (not shown) can be coupled to the optical fibers 601 by a variety of means, e.g. extending the optical fibers 601 to the light source, providing additional optical fibers or by other optical wave guides, as convenient for example between the light source and the optical fibers within the stack.

**FIGs. 19** **and** **20** depict an arrangement in which optical fibers 603 are provided outside the stack 502. The stack comprises plates. The different plates form one or more charged particle-optical elements. **FIG. 19** is a side cross-sectional view. By way of example, the stack 502 may comprise a control lens array 250, an objective lens array 241, a shield plate 73 and a detector 240. The control lens array 250 and the objective lens array 241 may have a common plate electrode. The different plates of the stack 502 may be fabricated using techniques commonly used for fabricating MEMS devices. The optical fibers 603 may extend between the light source to a planar optical member within the stack such as optical fibers 601 within the stack. Such a planar optical member may be a transparent optical plate, e.g. a wave guide, mounted on the bottom of the stack 502 as described above in relation to **FIGs. 13** to **16** or to fibers mounted on the bottom of the stack as shown in **FIGs. 17** and **18****.** It should be noted that although **FIG. 19** depicts the optical fibers extending to the bottom of the stack, the optical fibers 603 may extend to any of the plates of the stack for example for optically coupling to a planar optical member, desirably to the location of a field-free region within the stack (at least when operating) for example in which optical fibers 601 may be present within the stack.

**FIG. 20** is a plan view from below of the stack 502 showing a surface of the detector 240 that would in operation face a sample position. The surface of the detector 240 has a grid arrangement of detector elements 405. Although the grid arrangement is shown as hexagonal to ensure an optimal number of beams, e.g. a maximum number of beams, which may have sufficient beam current from source 201, and to enable a tessellation of adjacent surfaces scanned by the full beam grid, the grid arrangement may have another suitable shape such as circular, rectangular, square or rhombic. In a practical embodiment there may be many tens, many hundreds or many thousands, such as several tens or hundreds of thousands of detector elements 405 in the bottom of the stack 502.

The ends of the optical fibers 603 are spaced around the outside of the stack 502, for example along a side of the beam grid for example with a number of detector elements along the side of the grid per optical fiber 603. For example there may be a plurality of elements per optical fiber 603. There may be a plurality of optical fibers 603 per side. As illustrated for example there are four fibers 603 spaced along each side of the hexagonal stack 502, but this just a schematic representation.

The optical fibers 603 may be connected to one or more planar optical members so that the optical fibers 603 are in optical communication within the planar optical member(s). For example the optical fibers external to the stack may be in optical communication with optical elements within the planar optical member, for example optical fibers 601 within the planar optical member, (or optical plate or optical element). The optical fibers 603 external to the stack may be connected via respective optical connections to the optical waveguides and other optical elements such as optical fibers 601 within an optical planar member.

The light may be distributed through the planar optical member as in the arrangement described with respect to and shown in **FIG. 17****.** In an arrangement, the optical fibers may be in optical communication with multiple planar optical members. There may be more or fewer fibers per side of the grid. Desirably the number of fibers on each side of the grid (so for the stack) is the same and the fibers are evenly spaced. However, the number of fibers and their spacing may be varied, e.g. to accommodate mounting, power or signal connections to elements of the stack 502, provided that a reasonably uniform illumination of the sample 208 is achieved. It is to be noted that only the positions of the end points of the fibers 603 are important, for example to couple with a planar optical member within the stack; within the constraints of the fiber, e.g. minimum bending radius, routing of the fibers up the sides of the stack 502 may be arranged as convenient.

In an arrangement **FIG. 20** may be a plan view from below of the stack 502 (e.g. viewing the device up-beam from a down-beam end of the stack) showing a detector 240 having grid arrangement of detector elements 405 which may have the same features as the earlier described arrangement of **FIG. 20** unless described to the contrary. In the present arrangement, ends of the optical fibers 603 which are schematically represented by the circles 603 are positioned around the grid arrangement of detector elements 405 for example of the detector 240. The description above of the external optical fibers 603 relative to the sides of the grid may more specifically apply to the respective ends of the optical fibers 603; without however coupling to optical elements within the detector, for example an optical planar element that is within, or adjacent or otherwise associated with the detector 240 and, for example, its grid of detector elements 405. The number of ends of the optical fibers 603 and their spacing may be varied, e.g. to accommodate mounting, power or signal connections to elements of the stack 502, provided that their positions enable reasonably uniform illumination of the sample 208. For such illumination, the positions of the end points of the optical fibers 603 may be of more importance; within the constraints of the fiber, e.g. minimum bending radius, routing of the fibers up the sides of the stack 502 may be arranged as convenient.

In a practical embodiment, the diameter of the stack 502 may be of the order of 100 micron to 300 mm, for example 1 to 20 mm such as 3 to 5 mm. The spacing between the sample 208 and the bottom face of the stack may be of the order of 10 to 500 µm e.g. 10 to 100 µm. Therefore, stimulation light is desirably emitted from the ends of the fiber at an angle that exceeds a shearing angle relative to the sample surface, for example a threshold angle relative to the sample surface below which most if not all of the light is reflected (i.e. not absorbed by the material of the surface) The angle of the stimulation light relative to the sample surface is, for example, less than about 5 degrees, e.g. at about 1 degree. In this arrangement, the illumination of the sample 208 may be described as grazing incidence illumination. To achieve grazing incidence illumination, the end parts, e.g. the last several mm, of the fibers 603 may be oriented in the direction that the stimulation light is to be emitted. It is also possible to affect the angle that the stimulation light is emitted from the fibers 603 by appropriate angling or shaping of the end faces of the fibers 603 and/or by the provision of a lens, diffraction grating or dispersing feature or adjacent to the end of the fiber.

Alternatively or additionally, the surface of the stack facing the sample may have a surface topography. The end parts of the fibers 603 may be orientated towards the surface topography. The light from the end parts of the fibers may be reflected, diffracted and/or scattered towards the sample under inspection. The surface topography may have a region (such as a reflecting region, a scattering region, or a diffracting region) with a topography for the reflecting, scattering or diffracting. For example, the region may be for reflecting light towards a sample; the region may have a saw-toothed topography (or shape). Such surface topography for example with regions for reflecting light are disclosed in WO 2022228943 which is hereby incorporated by reference so far as the disclosure of such a surface topography.

It should be noted that it is generally not essential that all of the light emitted from the fibers be emitted at angles that illuminate the target portion of the sample 208. Since the power of stimulation light required is not large, a significant portion of the light exiting the fibers 603 may the incident elsewhere than the desired target potion on the sample without creating an excessive power draw on the source nor an excessive heat load on the sample or other parts of the apparatus.

As a variant of the arrangement of **FIGs. 19** and **20** featuring ends of the optical fibers 603 to illuminate a sample surface, some or all of the optical fibers may be arranged to provide light to an optical planar element mounted on the bottom of the stack 502 for example within, adjacent or associated with another planar element at the bottom of the stack 502, such as the detector 240, and/or another planar element within the stack. Such an optical planar element may be a transparent optical plate, e.g. a wave guide, as described above in relation to **FIGs. 13** to **16** or fibers mounted in, on, within or associated with a planar element of the stack such as the bottom of the stack as shown in **FIGs. 17** and **18****.** Such an arrangement may be used when there is insufficient space in the stack to fit an optical planar element capable of supplying light to the full beam grid and/or sufficiently evenly. The optical planar element may be used to supply light towards the center of the beam grid, e.g. within the stack. Light may be supplied directly from the end faces of fibers at the periphery of the beam grid, e.g. at the periphery of the stack.

In an embodiment the assessment charged particle-optical device and/or the preparatory charged particle-optical device comprises one or more charged particle-optical elements which comprise a microelectromechanical component (MEMS component). In an embodiment the assessment charged particle beam is a beam grid of a plurality of beams.

In an embodiment a surface of the assessment charged particle-optical device 106 that is configured to face the assessment location is an array of detectors.

In an embodiment the charged particle-optical apparatus comprises a controller configured to control one or more of the assessment charged particle-optical device, the preparatory charged particle-optical device and the light source.

In an embodiment a charged particle-optical apparatus comprises an actuatable stage 209 configured to support a sample 208. In an embodiment the actuatable stage 209 is configured to move the sample from the illumination location to the assessment location. In **FIG. 11****,** the movement of the actuatable stage 209 between the illumination location and the assessment location is indicated by the double ended arrow 108. In an embodiment the actuatable stage 209 is configured to move the sample from the illumination location to the assessment location after the light source has projected the light beam toward the illumination location. In an embodiment the actuatable stage is configured to move the sample into the assessment location before the assessment charged particle-optical device is configured to project the assessment charged particle beam toward the assessment location. In an embodiment the actuatable stage is configured to move the sample to the illumination location before the assessment charged particle-optical device is configured to project the assessment charged particle beam toward the assessment location.

In an embodiment, the electron-optical apparatus 40 comprises a plurality of electron-optical devices as depicted in the figures, for example at least **FIG. 3** and **FIG. 4****,** subject to the following comments, as a multi-column apparatus. Such a multi-column apparatus may comprise a plurality of electron-optical columns arranged in an array such as in a rectangular or hexagonal pattern. Each column of the multi-column apparatus may feature the features and functionality of the arrangement depicted in and disclosure in reference to **FIG. 3** herein. Alternatively, the multi-column apparatus may comprise a plurality of columns that are arranged in an array for example having a regular pattern and that comprise the features and functionality of the electron-optical device 41 depicted in and described with reference to **FIG. 4** subject to the following differences. Such differences include having an array of collimators, such as collimating deflectors for example integrated into the objective lens array assembly for example associated with, preferably immediately down-beam of, an aperture of the sub-beam forming array 252. Each collimating deflector is assigned to a respective sub-beam of the multi-beam. The differences may comprise an array of scan deflectors integrated into the objective lens array assembly for example associated with the objective lens array 241. Having a scan deflector array and collimator array is beneficial because such devices are electrostatic instead of magnetic. Electron-optical column architectures having magnetic devices are difficult to integrate into a multi-column arrangement because of the interference of the magnetic device with the surrounding columns of the multi-column arrangement.

Although the invention has been described primarily herein for an assessment charged particle device 106 as depicted in and described with reference to any of **FIGs. 3 to 5****,** the invention can be applied to a charged particle system having a single beam device or a multibeam device with a common, single magnetic objective lens, as the assessment charged particle device. Such a multibeam device may have: a magnetic condenser lens; an array of one or more electron-optical elements for example between the condenser lens and the objective lens; and a secondary column comprising a detector array for detecting a plurality of beams of charged particles from a sample. A Wien filter above the objective lens may separate charged particles from the sample in response to the multiple beam from the multibeam of charged particles directed towards the sample.

In an embodiment the method is for assessing the sample 208 by performing a voltage contrast measurement (an example of an assessment process). Suitable apparatus and associated method for such illumination of a sample and/or for such a voltage contrast measurement is herein disclosed and described.

Reference to a component or system of components or elements being controllable to manipulate an electron beam in a certain manner includes configuring a controller or control system or control unit to control the component to manipulate the electron beam in the manner described, as well optionally using other controllers or devices (e.g. voltage supplies and or current supplies) to control the component to manipulate the electron beam in this manner. For example, a voltage supply may be electrically connected to one or more components to apply potentials to the components, such as in a non-limited list the control lens array 250, the objective lens array 241, the condenser lenses 231, correctors, a collimator element array and scan deflector array, under the control of the controller or control system or control unit. An actuatable component, such as a stage, may be controllable to actuate and thus move relative to another components such as the beam path using one or more controllers, control systems, or control units to control the actuation of the component.

The embodiments herein described may take the form of a series of aperture arrays or electron-optical elements arranged in arrays along a beam or a multi-beam path. Such electron-optical elements may be electrostatic. In an embodiment all the electron-optical elements, for example from a sub-beam forming array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques).

References to upper and lower, up and down, above and below, top and bottom should be understood as referring to directions parallel to the (typically but not always vertical) up-beam and down-beam directions of the electron beam or multi-beam impinging on the sample 208. Thus, references to up-beam and down-beam are intended to refer to directions in respect of the beam path independently of any present gravitational field and even when a charged particle beam is absent for example when the charged particle apparatus is non-operational. However, it is understood that terms such as upper and lower, up and down, above and below, and/or top and bottom may easier to appreciate when a charged particle beam is not present, for example when the charged particle device is apart from the charged particle apparatus, for example a part thereof, such as the stack may be apart, such as removed, from the charged particle device, or one or more planar elements thereof, such as a detector 240, may be apart from the stack.

An electron-optical apparatus according to an embodiment of the disclosure may be a tool which makes a qualitative assessment of a sample (e.g. pass/fail), one which makes a quantitative measurement (e.g. the size of a feature) of a sample or one which generates an image of map of a sample. Examples of assessment systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron-optical column may be a component of an assessment system; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector.

References to elements being aligned along a beam path or sub-beam path are understood to mean that the respective elements are positioned along the beam path or sub-beam path.

Aspects of the invention are described in the following numbered clauses:
Clause 1. A plate for an electron-optical device configured to project a plurality of charged particle beams towards a sample, the device comprising the plate within the stack of plates, wherein in the plate is defined a plurality of apertures for respective paths of a plurality charged particle beams, and the plate comprises a planar optical member configured to direct stimulation light towards a sample so that the stimulation light is coincident with the paths of the plurality of charged particle beams towards the sample.
Clause 2. A stack for an electron-optical device configured to project a plurality of charged particle beams towards a sample, the stack comprising at least one of the plates of clause 1.
Clause 3. A stimulation module for use in an electron-optical projection device for projecting a plurality of charged particle beams towards a sample, the module comprising: a planar optical member configured to direct stimulation light towards a sample so that the stimulation light is coincident with the plurality of charged particle beams, in the plate is defined a plurality of apertures for respective paths of a plurality charged particle beams, and desirably the planar optical member is comprised a plate for example of a stack of plates arranged along the paths of a plurality of charged particle beams towards a sample.
Clause 4. An electron-optical projection device for projecting a plurality of charged particle beams towards a sample, the device comprising the stack of clause 2 or the stimulation module of clause 3.
Clause 5. An electron-optical projection device for projecting a plurality of charged particle beams towards a sample, the device comprising: a stack of plates comprising beam directing elements configured to project the plurality of charged particle beams towards a sample location on the sample, wherein at least one plate of the stack comprises a planar optical member configured to direct stimulation light towards the sample location so that the stimulation light is coincident with the plurality of charged particle beams, desirably coincident with the paths of the plurality of charged particle beams towards the sample location, desirably a plurality of apertures for respective paths of a plurality charged particle beams is defined in the at least one plate comprising an optical member.
Clause 6. The device of clause 5 wherein the planar optical member is configured to direct the stimulation light to be incident near, or at least partially overlapping a portion of individual electron beams at, the sample location, desirably the area illuminated by the stimulation light having a cross-sectional area at the sample position larger than the cross-section of the individual electron beams.
Clause 7. The device of clause 5 or 6 wherein the planar optical member is configured to direct the stimulation light to be incident simultaneously with the charged particle beams and/or prior to incidence of the charged particle beams.
Clause 8. The device of clause 5, 6 or 7 wherein the planar optical member comprises a transparent plate.
Clause 9. The device of clause 8 wherein the transparent plate has a thickness greater than twice the wavelength of the stimulation light and desirably in the range of from 5 µm to 50 µm.
Clause 10. The device of clause 8 or 9 wherein the transparent plate has an out-coupling feature configured to direct stimulation light to the sample, desirably the out-coupling feature comprising at least one of: a mirror or lensing surface for example a projection from a surface of the transparent plate facing the sample position, a projection facing away from the sample position; a recess in a surface of the transparent plate facing the sample position and/ or; a recess in a surface of the transparent plate facing away from the sample position; a diffraction grating; and a region of the transparent plate having a change in refractive index.
Clause 11. The device of clause 10 wherein the transparent plate has an out-coupling feature for each of the plurality of charged particle beams, desirably individual out-coupling features are positioned adjacent a respective aperture of the plurality of apertures, desirably the out-coupling feature is configured to direct the stimulation light in the direction of the sample position, along the path of an electron beam through the respective aperture.
Clause 12. The device of clause 5, 6 or 7 wherein the planar optical member comprises an optical system for example comprising a waveguide, a power splitters and an out-coupler such as a grating couplers.
Clause 13. The device of clause 12 wherein the optical system comprises a plurality of beam paths (desirably at least some of the beam paths pass between the apertures of the plurality of apertures) and a plurality of power splitters to split the stimulation light amongst the beam paths, desirably an individual power splitter on a beam path is configured to divide the beam path, desirably at least some of the power splitters are positioned along one or more of the beam paths, desirably an individual power splitter directs a beam path towards an individual aperture of the plurality of apertures.
Clause 14. The device of clause 12 or 13 wherein the optical system comprises a plurality of out-couplers, e.g. diffraction gratings, configured to direct stimulation light toward the sample.
Clause 15. The device of clause 14 wherein the optical system comprises an out-coupler, e.g. a diffraction grating, for each of the charged particle beams, desirably each positioned adjacent an aperture of the plurality of apertures.
Clause 16. The device of clause 15 wherein the optical system comprises a first diffraction grating and a second diffraction grating for each of the charged particle beams, desirably positioned adjacent an aperture of the plurality of apertures, the first diffraction grating having a different pitch than the second diffraction grating.
Clause 17. The device of clause 14, 15 or 16 wherein the diffraction gratings comprise overlapped gratings having different pitches and/or orientations.
Clause 18. The device of clause 12 or 13 wherein the optical system comprises a plurality of out-couplers, e.g. mirrors, configured to direct stimulation light toward the sample, desirably individual mirrors positioned adjacent an aperture of the plurality of apertures.
Clause 19. The device of any of clauses 5 to 18, wherein in the stack between the planar optical member and the sample location is another plate of the stack, desirably the planar optical member is configured to direct the stimulation light through apertures defined in the other plate, desirably the planar optical member is the most up-beam plate of the device
Clause 20. The device of any of clauses 5 to 19, wherein the planar optical member faces the sample position, desirably the planar optical member comprises a facing surface of the stack configured to face towards the sample position.
Clause 21. The device of any of clauses 5 to 20, wherein the planar optical element comprises a detector array, desirably an array of detectors each associated with a respective aperture of the plurality of apertures.
Clause 22. The device of any of clauses 5 to 21, wherein the planar optical element comprises an electrostatic electrode.
Clause 23. The device of clause 22, wherein the electrostatic electrode is a monolithic plate desirably with a single electrical contact; or the electrostatic electrode is a plurality of electrodes so that the planar optical element comprises a manipulator array such as a multipole array.
Clause 24. The device of any preceding clause further comprising a light source configured to generate the stimulation light, desirably the light source generating stimulation light having a wavelength in the range of from 450 nm to 850 nm, preferably from 450 nm to 800 nm; further desirably the stimulation light having multiple wavelengths; desirably the light source comprising one or more lasers.
Clause 25. The device of clause 24 further comprising an optical conduit, e.g. an optical fiber, configured to couple stimulation light from the light source to the optical member.
Clause 26. The device of any preceding clause wherein the stack of plates comprises a detector array configured to detect signal particles from the sample in response to the plurality of charged particle beams
Clause 27. The device of any preceding clause further comprising a potential supply system configured to apply an electrical potential to different plates of the stack for projecting the charged particle beams towards the sample.
Clause 28. The device of any preceding clause wherein one or more of the plates comprise an objective lens array for the charged particle beams.
Clause 29. The device of any preceding clause wherein the planar optical member is comprised in, for example affixed to, one of the plates.
Clause 30. The device of any preceding clause wherein the planar optical member is comprised in, for example affixed to, the plate that is closest to the sample amongst the plates of the stack.
Clause 31. An assessment charged particle-optical apparatus or a preparatory charged particle-optical apparatus comprising the device of any preceding clause, desirably when a planar optical element is located in an up-beamward direction of the device.
Clause 32. An assessment method using the device of any preceding clause.
Clause 33. An electron-optical projection device for projecting a plurality of charged particle beams towards a sample, the device comprising: a stack of plates comprising beam directing elements configured to project the plurality of charged particle beams towards a sample location on the sample, a plurality of optical fibers arranged outside the stack and configured to direct stimulation light towards the sample location so that the stimulation light is coincident with the plurality of charged particle beams.
Clause 34. The device of clause 33 wherein ends of the optical fibers are spaced around the bottom of the stack.
Clause 35. The device of clause 33 or 34 wherein the optical fibers emit light directly to the sample location.
Clause 36. The device of clause 33 or 34 wherein the optical fibers direct light into a planar optical member or one or more further optical fibers mounted on the bottom of the stack.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

## Claims

1. An electron-optical projection device for projecting a plurality of charged particle beams towards a sample, the device comprising:
a stack of plates comprising beam directing elements configured to project the plurality of charged particle beams towards a sample location on the sample,
wherein at least one plate of the stack comprises a planar optical member configured to direct stimulation light towards the sample location so that the stimulation light is coincident with the plurality of charged particle beams, desirably coincident with the paths of the plurality of charged particle beams towards the sample location, the at least one plate having a plurality of apertures for respective paths of a plurality charged particle beams.

2. The device of claim 1 wherein the planar optical member is configured to direct the stimulation light to be incident near, or at least partially overlapping a portion of individual electron beams at, the sample location, desirably the area illuminated by the stimulation light having a cross-sectional area at the sample position larger than the cross-section of the individual electron beams.

3. The device of claim 1 or 2 wherein the planar optical member comprises a transparent plate.

4. The device of claim 3 wherein the transparent plate has a thickness greater than twice the wavelength of the stimulation light and desirably in the range of from 5 µm to 50 µm.

5. The device of claim 3 or 4 wherein the transparent plate has an out-coupling feature configured to direct stimulation light to the sample, desirably the out-coupling feature comprising at least one of:
a. a mirror or lensing surface, for example: a projection from a surface of the transparent plate facing the sample position, a projection facing away from the sample position, a recess in a surface of the transparent plate facing the sample position and/or, a recess in a surface of the transparent plate facing away from the sample position;
b. a diffraction grating; and
c. a region of the transparent plate having a change in refractive index.

6. The device of claim 5 wherein the transparent plate has an out-coupling feature for each of the plurality of charged particle beams, desirably individual out-coupling features are positioned adjacent a respective aperture of the plurality of apertures,.

7. The device of claim 1 or 2 wherein the planar optical member comprises an optical system for example comprising a waveguide, a power splitter and an out-coupler such as a grating coupler.

8. The device of claim 7 wherein the optical system comprises a plurality of beam paths and a plurality of power splitters to split the stimulation light amongst the beam paths, desirably an individual power splitter on a beam path is configured to divide the beam pathdesirably an individual power splitter directs a beam path towards an individual aperture of the plurality of apertures.

9. The device of claim 7 or 8 wherein the optical system comprises a plurality of out-couplers, e.g. diffraction gratings, configured to direct stimulation light toward the sample.

10. The device of any of claims 1 to 9, wherein in the stack between the planar optical member and the sample location is another plate of the stack, desirably the planar optical member is configured to direct the stimulation light through apertures defined in the other plate,

11. The device of any of claims 1 to 10, wherein the plate comprises a detector array.

12. The device of claim 11, wherein the electrostatic electrode is a monolithic plate desirably with a single electrical contact; or the electrostatic electrode is a plurality of electrodes so that the plate comprises a manipulator array such as a multipole array.

13. The device of any of claims 1 to 12 further comprising a light source configured to generate the stimulation light, wherein the light source is configured to direct the stimulation light to be incident simultaneously with the charged particle beams and/or prior to incidence of the charged particle beams.

14. The device of claim 13 further comprising an optical conduit, e.g. an optical fiber, configured to couple stimulation light from the light source to the optical member.

15. The device of any of claims 1 to 14 wherein the planar optical member is comprised in, for example affixed to, the plate that is closest to the sample amongst the plates of the stack.
